(19) **Europäisches Patentamt**
**European Patent Office**
**Office européen des brevets**

(11) **EP 4 039 447 A1**

(12) **EUROPEAN PATENT APPLICATION**
published in accordance with Art. 153(4) EPC

(43) Date of publication:
**10.08.2022 Bulletin 2022/32**

(21) Application number: **20872017.7**

(22) Date of filing: **18.06.2020**

(51) International Patent Classification (IPC):
*B29C 63/02* (2006.01)    *B32B 27/06* (2006.01)
*C08J 5/12* (2006.01)    *C08J 5/18* (2006.01)
*B32B 15/08* (2006.01)    *B32B 37/00* (2006.01)
*B32B 37/16* (2006.01)    *G09F 9/00* (2006.01)
*G09F 9/30* (2006.01)    *H01L 21/02* (2006.01)
*H01L 21/304* (2006.01)    *B29C 65/48* (2006.01)
*B32B 7/12* (2006.01)    *B32B 38/18* (2006.01)
*C08J 7/043* (2020.01)    *C08J 7/12* (2006.01)

(52) Cooperative Patent Classification (CPC):
**B29C 63/02; B29C 65/48; B32B 7/12; B32B 15/08;**
**B32B 27/06; B32B 37/00; B32B 37/16;**
**B32B 38/18; C08J 5/12; C08J 5/18; C08J 7/043;**
**C08J 7/12; G09F 9/00; G09F 9/30; H01L 21/02;**

(Cont.)

(86) International application number:
**PCT/JP2020/024005**

(87) International publication number:
**WO 2021/065101 (08.04.2021 Gazette 2021/14)**

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(30) Priority:  **02.10.2019  JP 2019182016**
          **28.01.2020  JP 2020011313**
          **28.01.2020  JP 2020011498**
          **13.03.2020  JP 2020044268**

(71) Applicant: **TOYOBO CO., LTD.**
**Osaka-shi**
**Osaka 5300001 (JP)**

(72) Inventors:
- **OKUYAMA,Tetsuo**
  **Otsu-shi, Shiga 520-0292 (JP)**
- **TOKUDA,Kaya**
  **Otsu-shi, Shiga 520-0292 (JP)**
- **OUYA,Kazuyuki**
  **Otsu-shi, Shiga 520-0292 (JP)**
- **WATANABE,Naoki**
  **Otsu-shi, Shiga 520-0292 (JP)**

(74) Representative: **Vossius & Partner**
**Patentanwälte Rechtsanwälte mbB**
**Siebertstraße 3**
**81675 München (DE)**

(54) **APPARATUS FOR MANUFACTURING LAMINATE AND METHOD FOR MANUFACTURING LAMINATE**

(57)    This apparatus for manufacturing a laminate comprises: a first sheet transporting device for transporting a first sheet; a water supply device for supplying an aqueous medium to the surface of the first sheet coated with a silane coupling agent and/or the surface of a second sheet coated with a silane coupling agent; and a laminating device for attaching the first sheet and the second sheet which have been supplied with the aqueous medium.

**EP 4 039 447 A1**

Fig.1

(52) Cooperative Patent Classification (CPC): (Cont.)
**H01L 21/304**

**2**

**Description**

TECHNICAL FIELD

The present invention relates to an apparatus for manufacturing a laminate and a method for manufacturing a laminate.

BACKGROUND ART

In recent years, for the purpose of decreasing the weight, size, and thickness of and imparting flexibility to functional elements such as semiconductor elements, MEMS elements, and display elements, technological development for forming these elements on polymer films has been actively carried out. In other words, as materials for substrates of electronic parts such as information and communication equipment (broadcasting equipment, mobile radio, portable communication equipment, and the like), radar, and high-speed information processing equipment, ceramics which exhibit heat resistance and can cope with increases in frequencies (reaching the GHz band) of the signal band of information and communication equipment have been conventionally used. However, ceramics are not flexible and are also hardly thinned and thus have a drawback that the applicable fields are limited, and polymer films have recently been used as substrates.

When functional elements such as semiconductor elements, MEMS elements, and display elements are formed on the surface of polymer films, it is ideal to perform processing by a so-called roll-to-roll process which utilizes the flexibility that is a property of polymer films. However, in industries such as semiconductor industry, MEMS industry, and display industry, process technologies for rigid flat substrates such as wafer bases or glass substrate bases have been so far constructed. Hence, in order to form functional elements on polymer films utilizing the existing infrastructure, a process is used in which the polymer films are bonded to, for example, rigid supports (for example, inorganic substrates and metal foils) formed of inorganic substances such as glass plates, ceramic plates, silicon wafers, and metal plates, desired elements are formed on the laminates, and then the polymer films and desired elements are peeled off from the supports.

However, in the process of forming desired wiring and a desired functional element on a laminate in which a polymer film and a support formed of an inorganic substance are bonded to each other, the laminate is often exposed to a high temperature. For example, in the formation of functional elements such as polysilicon and oxide semiconductors, a step performed in a temperature region of about 200°C to 600°C is required. In addition, a temperature of about 200°C to 300°C may be applied to the film when a hydrogenated amorphous silicon thin film is fabricated, and heating at about 450°C to 600°C may be required in order to heat and dehydrogenate amorphous silicon and obtain low-temperature polysilicon. Hence, the polymer film composing the laminate is required to exhibit heat resistance, but as a practical matter, polymer films which can withstand practical use in such a high temperature region are limited. In addition, it is generally conceivable to use a pressure sensitive adhesive or an adhesive to bond a polymer film to a support, but heat resistance is also required for the joint surface (namely, the adhesive or pressure sensitive adhesive for bonding) between the polymer film and the support at that time. However, since ordinary adhesives and pressure sensitive adhesives for bonding do not exhibit sufficient heat resistance, bonding with an adhesive or a pressure sensitive adhesive cannot be adopted when the formation temperature of functional element is high.

Since there are no pressure sensitive adhesives or adhesives exhibiting sufficient heat resistance, a technology in which a polymer solution or a polymer precursor solution is applied onto a support, and dried and cured on the support to be formed into a film, and used for these applications has been conventionally adopted in the above-described applications. However, the polymer film obtained by such means is brittle and easily torn and thus the functional element formed on the surface of this polymer film is often destroyed when being peeled off from the support. In particular, it is extremely difficult to peel off a large-area film from a support, and it is not possible to attain an industrially viable yield.

In view of these circumstances, a laminate in which a polyimide film which exhibits excellent heat resistance, is tough, and can be thinned is bonded to a support with a silane coupling agent interposed therebetween has been proposed as a laminate of a polymer film and a support for manufacturing a so-called flexible electronic device in which a functional element is formed on a flexible substrate (for example, see Patent Documents 1 to 3).

In recent years, silane coupling agents are widely used to improve the wettability, adhesive properties and the like of both inorganic materials such as glass and polymer resins at the interface. Silane coupling agents have strong adsorptive power to inorganic materials, and at the same time, easily undergo self-condensation reaction. Hence, particles of the condensate are formed in the treatment liquid and the coating liquid, and these particles often become foreign matter defects on the coated surface and the treated surface.

In order to solve such a problem, for example, Patent Document 4 discloses a technology in which a silane coupling agent is applied to a substrate in a gas phase state. According to such a method, it is possible to realize an extremely thin silane coupling agent layer with less defects.

PRIOR ART DOCUMENTS

PATENT DOCUMENTS

Patent Document 1: JP-B-5152104
Patent Document 2: JP-B-5304490
Patent Document 3: JP-B-5531781
Patent Document 4: JP-A-2015-178237

SUMMARY OF THE INVENTION

PROBLEMS TO BE SOLVED BY THE INVENTION

In the above-described laminate (laminate as exemplified in Patent Documents 1 to 3), it is intended that the support is easily peeled off from the polyimide film after device formation as well as the support is prevented from peeling off from the polyimide film before and during device formation by interposing a layer containing a silane coupling agent between the support and the heat-resistant polymer film.

However, when a large-area laminate is manufactured, it is extremely difficult to control the adhesive strength to be uniform all over the laminate.

Since the silane coupling agent coated-layer with less defects, which is obtained by the method as described in Patent Document 4 is extremely thin, a foreign matter introduced into the coated surface may hinder the reaction of the silane coupling agent-coated surface even if the foreign matter is minute.

The present invention has been made in view of the above-described problems. In other words, an object of the present invention is to provide an apparatus for manufacturing a laminate, by which the adhesive strength between a first sheet (for example, inorganic substrate, metal foil, or first heat-resistant polymer film) and a second sheet (for example, second heat-resistant polymer film) can be uniformly controlled. An object of the present invention is to provide a method for manufacturing a laminate, by which the adhesive strength between a first sheet and a second sheet can be uniformly controlled.

MEANS FOR SOLVING THE PROBLEMS

In view of this situation, the present inventors have continuously conducted diligent research, and as a result, found out an apparatus for manufacturing a laminate and a method for manufacturing a laminate, by which the adhesive strength can be uniformly controlled in a large area as well, by adopting the following configuration, and thus completed the present invention.

In other words, the apparatus for manufacturing a laminate according to the present invention includes:

a first sheet transporting device for transporting a first sheet;
a water supply device for supplying an aqueous medium to a surface of a first sheet coated with a silane coupling agent and/or a surface of a second sheet coated with a silane coupling agent; and
a laminating device for bonding the first sheet and the second sheet, which have been supplied with the aqueous medium, to each other.

Conventionally, in a laminate of a first sheet (for example, inorganic substrate, metal foil, or first heat-resistant polymer film) and a second sheet (for example, second heat-resistant polymer film), particularly when the laminate has a large area, it is difficult to homogenously apply a silane coupling agent, and as a result, it is difficult to uniformly and properly control the adhesive strength between the first sheet and the second sheet.

However, according to the configuration, the first sheet and the second sheet can be bonded to each other in a state in which an aqueous medium is supplied to the surface of the first sheet coated with a silane coupling agent and/or the surface of the second sheet coated with a silane coupling agent.

When an aqueous medium is supplied to the surface of the first sheet coated with a silane coupling agent and/or the surface of the second sheet coated with a silane coupling agent, a state is obtained in which at least a part of the silane coupling agent is dissolved in the aqueous medium. The silane coupling agent layer can be thus flattened immediately before bonding. More specifically, since the first sheet and the second sheet can be laminated while the aqueous medium is extruded from the bonding surface at the time of bonding, the excess silane coupling agent between the first sheet and the second sheet can be removed, and the amount of the silane coupling agent is controlled to the minimum necessary amount coordinated on the surface of at least either of the first sheet or the second sheet by the affinity. As a result, the adhesive strength can be uniformly controlled. Since the bonding can be performed in a state in which at least a part of the silane coupling agent is dissolved in the aqueous medium, the adhesive strength can be improved.

In the configuration, it is preferable to provide a coating device for coating a first sheet with a silane coupling agent.

When the coating device is included, the first sheet can be coated with a silane coupling agent.

In the configuration, it is preferable to include a first substrate cleaning device for cleaning a first sheet before being supplied with an aqueous medium.

When the first cleaning device is included, the first sheet before being supplied with an aqueous medium can be cleaned. As a result, it is possible to obtain a laminate with fewer foreign matters mixed.

In the configuration, it is preferable to include a second cleaning device for cleaning a second sheet before being supplied with an aqueous medium.

When the second cleaning device is included, the second sheet before being supplied with an aqueous medium can be cleaned. As a result, it is possible to obtain a laminate with fewer foreign matters mixed.

The method for manufacturing a laminate according to the present invention is a method for manufacturing a laminate including a first sheet and a second sheet, which includes:

a step A of supplying an aqueous medium to a surface of a first sheet coated with a silane coupling agent and/or a surface of a second sheet coated with a silane coupling agent; and

a step B of bonding the first sheet and the second sheet, which have been supplied with the aqueous medium, to each other.

According to the configuration, the first sheet and the second sheet can be bonded to each other in a state in which an aqueous medium is supplied to the surface of the first sheet coated with a silane coupling agent and/or the surface of the second sheet coated with a silane coupling agent.

When an aqueous medium is supplied to the surface of the first sheet coated with a silane coupling agent and/or the surface of the second sheet coated with a silane coupling agent, a state is obtained in which at least a part of the silane coupling agent is dissolved in the aqueous medium. The silane coupling agent layer can be thus flattened immediately before bonding. More specifically, since the first sheet and the second sheet can be laminated while the aqueous medium is extruded from the bonding surface at the time of bonding, the excess silane coupling agent between the first sheet and the second sheet can be removed, and the amount of the silane coupling agent is controlled to the minimum necessary amount coordinated on the surface of at least either of the first sheet or the second sheet by the affinity. As a result, the adhesive strength can be uniformly controlled. Since the bonding can be performed in a state in which at least a part of the silane coupling agent is dissolved in the aqueous medium, the adhesive strength can be improved.

In the configuration, it is preferable to include a step X-1 of coating a first sheet with a silane coupling agent before the step A.

When the step X-1 is included, the first sheet can be coated with a silane coupling agent.

In the configuration, it is preferable to include a step X-2 of cleaning a first sheet before the step A.

When the step X-2 is included, the first sheet before being supplied with an aqueous medium can be cleaned. As a result, it is possible to obtain a laminate with fewer foreign matters mixed.

In the configuration, it is preferable to include a step X-3 of cleaning a second sheet before the step A.

When the step X-3 is included, the second sheet before being supplied with an aqueous medium can be cleaned. As a result, it is possible to obtain a laminate with fewer foreign matters mixed.

In the configuration, it is preferable to include a step X-4 of inspecting appearance of a laminate of a first sheet and a second sheet, which have been bonded to each other, after the step B.

When the step X-4 is included, it is possible to confirm the presence or absence of foreign matters mixed in the laminate.

EFFECT OF THE INVENTION

According to the present invention, it is possible to provide an apparatus for manufacturing a laminate, by which the adhesive strength between a first sheet and a second sheet can be uniformly controlled. According to the present invention, it is possible to provide a method for manufacturing a laminate, by which the adhesive strength between a first sheet and a second sheet can be uniformly controlled.

BRIEF DESCRIPTION OF THE DRAWINGS

Fig. 1 is a schematic diagram for explaining an apparatus for manufacturing a laminate according to a first embodiment.
Fig. 2 is a schematic diagram for explaining an apparatus for manufacturing a roll laminate according to a second embodiment.
Fig. 3 is a schematic diagram for explaining an apparatus for manufacturing a heat-resistant polymer film laminate according to a third embodiment.
Fig. 4 is a schematic diagram of a device for coating a glass substrate with a silane coupling agent.

MODE FOR CARRYING OUT THE INVENTION

Hereinafter, embodiments of the present invention will be described.
The apparatus for manufacturing a laminate according to the present embodiment includes:

a first sheet transporting device for transporting a first sheet;
a water supply device for supplying an aqueous medium to a surface of a first sheet coated with a silane coupling agent and/or a surface of a second sheet coated with a silane coupling agent; and
a laminating device for bonding the first sheet and the second sheet, which have been supplied with the aqueous medium, to each other.

The method for manufacturing a laminate according to the present embodiment is a method for manufacturing a laminate including a first sheet and a second sheet, which includes:

a step A of supplying an aqueous medium to a surface of a first sheet coated with a silane coupling agent and/or a surface of a second sheet coated with a silane coupling agent; and
a step B of bonding the first sheet and the second sheet, which have been supplied with the aqueous medium, to each other.

The apparatus for manufacturing a laminate according to the present embodiment includes the apparatuses for manufacturing a laminate according to the first to third embodiments described below. The method for manufacturing a laminate according to the present embodiment includes the methods for manufacturing a laminate according to the first to third embodiments described below.

[First embodiment]

The apparatus for manufacturing a laminate according to the first embodiment has the following configurations.

(1) An apparatus for manufacturing a laminate, the apparatus including:

an inorganic substrate transporting device for transporting an inorganic substrate;
a water supply device for supplying an aqueous medium to a surface of an inorganic substrate coated with a silane coupling agent and/or a surface of a heat-resistant polymer film coated with a silane coupling agent; and
a laminating device for bonding the inorganic substrate and the heat-resistant polymer film, which have been supplied with the aqueous medium, to each other.

(2) The apparatus for manufacturing a laminate according to (1), which includes a coating device for coating an inorganic substrate with a silane coupling agent.
(3) The apparatus for manufacturing a laminate according to (1) or (2), which includes an inorganic substrate cleaning device for cleaning an inorganic substrate before being supplied with an aqueous medium.
(4) The apparatus for manufacturing a laminate according to any one of (1) to (3), which includes a film cleaning device for cleaning a heat-resistant polymer film before being supplied with an aqueous medium.
(5) The apparatus for manufacturing a laminate according to any one of (1) to (4), which includes an appearance inspecting device for inspecting appearance of a laminate of an inorganic substrate and a heat-resistant polymer film, which have been bonded to each other by the laminating device.
(6) The apparatus for manufacturing a laminate according to (5), which includes a peeling device for peeling off a heat-resistant polymer film from a laminate judged to have poor appearance by the appearance inspecting device.

(7) The apparatus for manufacturing a laminate according to any one of (1) to (6), in which the inorganic substrate transporting device is an electrically driven roller conveyor.

(8) The apparatus for manufacturing a laminate according to any one of (1) to (7), in which the heat-resistant polymer film is rectangular, has an area of 0.65 m$^2$ or more, and has a side of at least 700 mm or more.

(9) The apparatus for manufacturing a laminate according to any one of (1) to (8), in which a pressing pressure of the laminating device is 0.5 MPa or less.

The method for manufacturing a laminate according to the first embodiment has the following configurations.

(10) A method for manufacturing a laminate, which is a method for manufacturing a laminate including an inorganic substrate and a heat-resistant polymer film in this order, the method including:

a step A of supplying an aqueous medium to a surface of an inorganic substrate coated with a silane coupling agent and/or a surface of a heat-resistant polymer film coated with a silane coupling agent; and

a step B of bonding the inorganic substrate and the heat-resistant polymer film, which have been supplied with the aqueous medium, to each other.

(11) The method for manufacturing a laminate according to (10), which includes a step X-1 of coating an inorganic substrate with a silane coupling agent before the step A.

(12) The method for manufacturing a laminate according to (11), which includes a step X-2 of cleaning an inorganic substrate before the step A and the step X-1.

(13) The method for manufacturing a laminate according to any one of (10) to (12), which includes a step X-3 of cleaning a heat-resistant polymer film before the step A.

(14) The method for manufacturing a laminate according to any one of (10) to (13), which includes a step X-4 of inspecting appearance of a laminate of an inorganic substrate and a heat-resistant polymer film, which have been bonded to each other, after the step B.

(15) The method for manufacturing a laminate according to (14), which includes a step X-5 of peeling off a heat-resistant polymer film from a laminate judged to have poor appearance in the step X-4.

(16) The method for manufacturing a laminate according to any one of (10) to (15), in which the heat-resistant polymer film is rectangular, has an area of 0.65 m$^2$ or more, and has a side of at least 700 mm or more.

(17) The method for manufacturing a laminate according to any one of (10) to (16), in which a pressing pressure in a step B is 0.5 MPa or less.

In the first embodiment, the "inorganic substrate" corresponds to the "first sheet" in the present embodiment, the "inorganic substrate transporting device" corresponds to the "first sheet transporting device" in the present embodiment, the "heat-resistant polymer film" corresponds to the "second sheet" in the present embodiment, the "inorganic substrate cleaning device" corresponds to the "first cleaning device" in the present embodiment, and the "film cleaning device" corresponds to the "second cleaning device" in the present embodiment.

Hereinafter, the apparatus for manufacturing a laminate and the method for manufacturing a laminate according to the first embodiment will be specifically described.

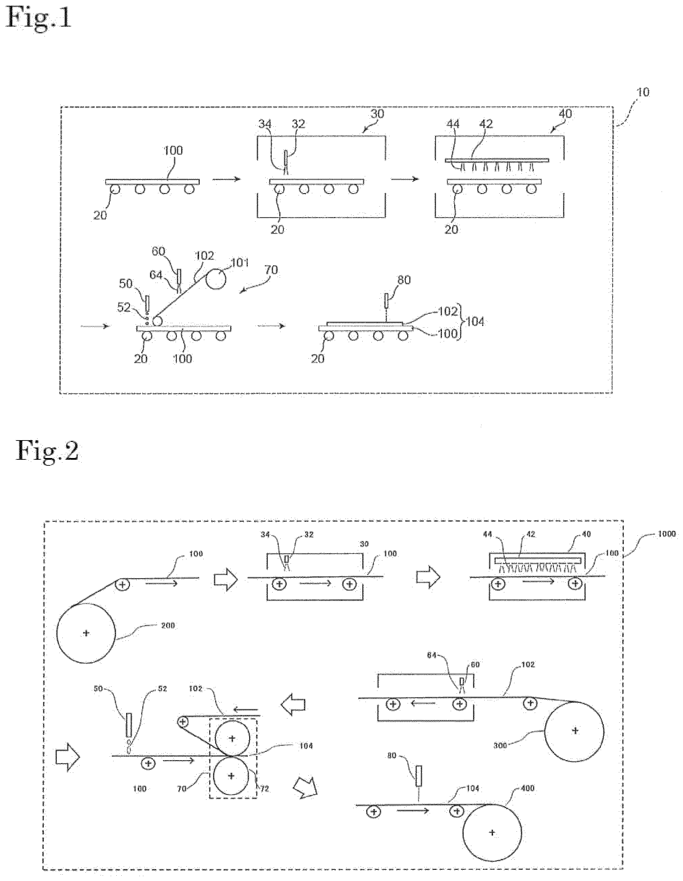

Fig. 1 is a schematic diagram for explaining the apparatus for manufacturing a laminate according to the first embodiment.

As illustrated in Fig. 1, an apparatus for manufacturing a laminate 10 according to the first embodiment includes an inorganic substrate transporting device 20, an inorganic substrate cleaning device 30, a coating device 40, a water supply device 50, a film cleaning device 60, a laminating device 70, and an appearance inspecting device 80. However, the apparatus for manufacturing a laminate in the present invention is only required to include at least a first sheet transporting device (inorganic substrate transporting device), a water supply device, and a laminating device.

The inorganic substrate transporting device 20 transports an inorganic substrate 100 and moves the inorganic substrate 100 between the respective devices included in the apparatus for manufacturing a laminate 10. The inorganic substrate transporting device 20 is not particularly limited as long as it can transport the inorganic substrate 100, but is preferably an electrically driven roller conveyor. When the inorganic substrate transporting device 20 is an electrically driven roller conveyor, it is possible to automate the manufacture of a laminate so that a laminate can be manufactured while sequentially moving the inorganic substrates.

The inorganic substrate cleaning device 30 includes a cleaning liquid spray nozzle 32, an air knife (not illustrated), and the like. The inorganic substrate cleaning device 30 can spray a cleaning liquid 34 onto the inorganic substrate 100 and then dry the surface of the inorganic substrate 100 by blowing air on the surface using the air knife. The first cleaning device (inorganic substrate cleaning device) according to the present invention is not limited to the above-described inorganic substrate cleaning device 30 as long as it can clean the first sheet (inorganic substrate) before being supplied with an aqueous medium, and conventionally known ones can be adopted.

The coating device 40 includes a silane coupling agent supply pipe 42 provided with a plurality of small holes, and the like. The coating device 40 can coat the inorganic substrate 100 with a silane coupling agent 44 from the silane coupling agent supply pipe 42. The coating device according to the present invention is not limited to the above-described coating device 40 as long as it can coat the inorganic substrate with a silane coupling agent, and conventionally known ones can be adopted.

The water supply device 50 supplies an aqueous medium 52 to the surface of the inorganic substrate 100 coated with a silane coupling agent. The configuration of the water supply device 50 is not particularly limited as long as it can supply the aqueous medium 52 to the surface of the inorganic substrate 100 coated with a silane coupling agent, and conventionally known ones can be adopted. The amount of the aqueous medium 52 supplied is not particularly limited, but is preferably about 0.1 to 50 g/100 cm$^2$ from the viewpoint of decreasing bubbles and foreign matters.

The film cleaning device 60 can clean the surface of a heat-resistant polymer film 102 by spraying a cleaning liquid 64 onto the heat-resistant polymer film 102 supplied from a roll 101 and then blowing air on the surface using an air knife (not illustrated). The second cleaning device (film cleaning device) according to the present invention is not limited to the above-described film cleaning device 60 as long as it can clean the second sheet (heat-resistant polymer film) before being supplied with an aqueous medium, and conventionally known ones can be adopted.

The laminating device 70 includes a laminating roller 72 and the like. The laminating device 70 bonds the inorganic substrate 100 and the heat-resistant polymer film 102, which have been supplied with the aqueous medium 52, to each other by performing pressing using the laminating roller 72. The pressing pressure at the time of bonding is preferably 0.5 MPa or less. According to the apparatus for manufacturing a laminate 10, the bonding can be performed in a state in which at least a part of the silane coupling agent 44 is dissolved in the aqueous medium 52, and thus the pressing pressure at the time of lamination can be lowered. The laminating device according to the present invention is not limited to the above-described laminating device 70 as long as it can bond the inorganic substrate and the heat-resistant polymer film, which have been supplied with an aqueous medium, to each other, and conventionally known ones can be adopted.

The pressing pressure of the laminating device 70 is preferably 0.5 MPa or less. Since the bonding can be performed in a state in which at least a part of the silane coupling agent is dissolved in the aqueous medium, the pressing pressure at the time of lamination can be lowered. When the pressing pressure is 0.5 MPa or less, it is possible to suppress damage to the inorganic substrate.

The lower limit of the pressing pressure is not particularly limited, but is preferably 0.1 MPa or more. When the pressing pressure is 0.1 MPa or more, it is possible to prevent the generation of a portion that is not in close contact and insufficient adhesion. The temperature at the time of pressurization is preferably 10°C to 60°C, more preferably 20°C to 40°C. The aqueous solution may vaporize and generate bubbles and the polymer film may be damaged when the temperature is too high, and the close contact force tends to be weak when the temperature is too low. There is no problem when pressurization is carried out at room temperature (near room temperature) without special temperature control as well.

After that, high temperature treatment (high temperature treatment without pressurization) or high temperature pressurization is performed. The pressing pressure at the time of high temperature pressurization is preferably 0.5 MPa or less. The temperature at the time of the high temperature treatment and high temperature pressurization is, for example, 80°C or more, more preferably 100°C to 250°C, still more preferably 120°C to 220°C, particularly preferably 90°C to 140°C. By performing high temperature pressurization, the chemical reaction at the close contact interface is promoted and the polymer film and the inorganic substrate can be laminated.

Although the pressurization treatment can be performed in an atmosphere at the atmospheric pressure, it may be possible to obtain uniform adhesive force by performing the pressurization treatment in a vacuum. As the degree of vacuum, a degree of vacuum obtained by an ordinary oil-sealed rotary pump, namely, about 10 Torr or less is sufficient.

As a device that can be used for the pressurization and heating treatment, for example, an "11FD" manufactured by Imoto Machinery Co., Ltd. or the like can be used for performing pressing in a vacuum. For example, "MVLP" manufactured by MEIKI CO., LTD. or the like can be used for performing vacuum lamination using a roll-type film laminator in a vacuum or a film laminator for evacuating the air and then applying pressure at once to the entire surface of glass by a thin rubber film.

The appearance inspecting device 80 inspects the appearance of a laminate 104 of the inorganic substrate 100 and the heat-resistant polymer film 102, which have been bonded to each other by the laminating device 70. As the appearance inspecting device 80, for example, an automated optical inspection (AOI) device can be adopted. The appearance inspecting device 80 judges whether or not foreign matters are mixed in the laminate 104 and whether or not there is bonding unevenness based on the image acquired by the CCD camera (the image on the heat-resistant polymer film 102 side of the laminate 104) and the preset (quantified) data. The appearance inspecting device according to the present invention is not limited to the above-described appearance inspecting device 80 as long as it can inspect the appearance of the laminate of the inorganic substrate and the heat-resistant polymer film, and conventionally known ones can be adopted.

The apparatus for manufacturing a laminate 10 includes a peeling device (not illustrated). The peeling device peels off the heat-resistant polymer film 102 from the laminate 104 judged to have poor appearance by the appearance inspecting device 80. As the peeling device, conventionally known ones can be adopted. Since the peeling device is included, the heat-resistant polymer film 102 can be peeled off from the laminate 104 judged to have poor appearance. As a result, the inorganic substrate 100 can be reused immediately.

In the above-described embodiment, the case where the coating device 40 for coating an inorganic substrate with a silane coupling agent is included has been described. However, the present invention is not limited to this example, and a device for coating the second sheet (heat-resistant polymer film) with a silane coupling agent may be included instead of the coating device 40 for coating the first sheet (inorganic substrate) with a silane coupling agent. A device for coating the second sheet (heat-resistant polymer film) with a silane coupling agent may be included in addition to the coating device 40 for coating the first sheet (inorganic substrate) with a silane coupling agent.

In the above-described embodiment, the case where the coating device 40 for coating an inorganic substrate with a silane coupling agent is included has been described. However, in the present invention, the coating device 40 for coating the first sheet (inorganic substrate) with a silane coupling agent may not be included. In this case, for example, the first sheet (inorganic substrate) coated with a silane coupling agent in advance may be used.

The apparatus for manufacturing a laminate 10 according to the first embodiment has been described above.

Next, the method for manufacturing a laminate according to the first embodiment will be described. Hereinafter, the method for manufacturing a laminate in the case of using the apparatus for manufacturing a laminate 10 will be described, but the present invention is not limited to this example. For example, a worker and the like may carry out the step carried out by each device.

The method for manufacturing a laminate according to the first embodiment is a method for manufacturing a laminate including an inorganic substrate and a heat-resistant polymer film in this order, which includes:

a step A of supplying an aqueous medium to a surface of an inorganic substrate coated with a silane coupling agent; and
a step B of bonding the inorganic substrate after being supplied with the aqueous medium and a heat-resistant polymer film to each other.

It is preferable that the method for manufacturing a laminate further includes:

a step X-2 of cleaning an inorganic substrate;
a step X-1 of coating an inorganic substrate with a silane coupling agent after the step X-2;
a step X-3 of cleaning a heat-resistant polymer film;
a step X-4 of inspecting appearance of a laminate of an inorganic substrate and a heat-resistant polymer film, which have been bonded to each other, after the step B; and
a step X-5 of peeling off a heat-resistant polymer film from a laminate judged to have poor appearance in the step X-4.

In the method for manufacturing a laminate, first, the inorganic substrate 100 is moved in the direction of the inorganic substrate cleaning device 30 by the inorganic substrate transporting device 20, and the inorganic substrate is cleaned by the substrate cleaning device 30 (step X-2).

Next, the inorganic substrate 100 is moved in the direction of the coating device 40 by the inorganic substrate transporting device 20, and the inorganic substrate is coated with a silane coupling agent by the coating device 40 (step X-1).

Meanwhile, the surface of the heat-resistant polymer film 102 is cleaned by the film cleaning device 60 by spraying the cleaning liquid 64 onto the heat-resistant polymer film 102 supplied from the roll 101 and then blowing air on the surface using the air knife (not illustrated) (step X-3).

Next, the aqueous medium 52 is supplied to the surface of the inorganic substrate 100 coated with a silane coupling agent by the water supply device 50 (step A).

Next, the inorganic substrate 100 after being supplied with the aqueous medium 52 and the heat-resistant polymer film 102 are bonded to each other by the laminating device 70 (step B).

Next, the appearance of the laminate 104 of the inorganic substrate 100 and the heat-resistant polymer film 102, which have been bonded to each other, by the appearance inspecting device 80 (step X-4).

Next, the heat-resistant polymer film 102 is peeled from the laminate 104 judged to have poor appearance in the step X-4 by the peeling device (step X-5).

In the above-described embodiment, the case where the inorganic substrate is coated with a silane coupling agent has been described. However, the present invention is not limited to this example, and the second sheet (heat-resistant polymer film) may be coated with a silane coupling agent instead of coating the first sheet (inorganic substrate) with a silane coupling agent. The second sheet (heat-resistant polymer film) may be coated with a silane coupling agent as well as the first sheet (inorganic substrate) is coated with a silane coupling agent.

In the above-described embodiment, the case where the inorganic substrate is coated with a silane coupling agent has been described. However, in the present invention, the step of coating the first sheet (inorganic substrate) with a silane coupling agent may not be included. In this case, for example, the first sheet (inorganic substrate) coated with a silane coupling agent in advance may be used.

The method for manufacturing a laminate according to the first embodiment has been described above.

Next, the heat-resistant polymer film, the inorganic substrate, the silane coupling agent, and the aqueous medium will be described.

In the present specification, the heat-resistant polymer has a melting point of preferably 250°C or more, more preferably 300°C or more, and the upper limit of the melting point is not particularly limited and may be the same as the decomposition temperature of the heat-resistant polymer. The heat-resistant polymer is a polymer having a glass transition temperature of preferably 250°C or more, more preferably 320°C or more, still more preferably 380°C or more and preferably 500°C or less, more preferably 450°C or less. Hereinafter, the heat-resistant polymer is also simply referred to as a polymer in order to avoid complication. In the present specification, the melting point and the glass transition temperature are determined by differential thermal analysis (DSC). In a case where the melting point exceeds 500°C, it may be determined whether or not the temperature has reached the melting point by visually observing the thermal deformation behavior when the heat-resistant polymer is heated at this temperature.

Examples of the heat-resistant polymer film (hereinafter, also simply referred to as a polymer film or also simply referred to as a film) include films of polyimide-based resins (for example, aromatic polyimide resin and alicyclic polyimide resin) such as polyimide, polyamide-imide, polyetherimide, and fluorinated polyimide; copolymerized polyesters (for example, fully aromatic polyesters, semi-aromatic polyesters) such as polyethylene, polypropylene, polyethylene terephthalate, polybutylene terephthalate, and polyethylene-2,6-naphthalate; copolymerized (meth)acrylate typified by polymethyl methacrylate; polycarbonate; polyamide; polysulfone; polyether sulfone; polyether ketone; cellulose acetate; cellulose nitrate; aromatic polyamide; polyvinyl chloride; polyphenol; polyarylate; polyphenylene sulfide; polyphenylene oxide; polystyrene; polybenzoxazole (aromatic polybenzoxazole); polybenzothiazole (aromatic polybenzothiazole); polybenzimidazole (aromatic polybenzimidazole); and the like.

Among the polymer films, a film obtained using a so-called super engineering plastic is preferable, and more specific examples thereof include an aromatic polyimide film, an aromatic polyamide film, an aromatic polyamide-imide film, an aromatic polybenzoxazole film, an aromatic polybenzothiazole film, and an aromatic polybenzimidazole film.

The details of the polyimide-based resin film (referred to as a polyimide film in some cases) which is an example of the polymer film will be described below. Generally, the polyimide-based resin film is obtained by applying a polyamic acid (polyimide precursor) solution which is obtained by a reaction between a diamine and a tetracarboxylic acid in a solvent, to a support for polyimide film fabrication, drying the solution to form a green film (hereinafter, also called as a "polyamic acid film"), and treating the green film by heat at a high temperature to cause a dehydration ring-closure reaction on the support for polyimide film fabrication or in a state of being peeled off from the support.

For the application of the polyamic acid (polyimide precursor) solution, it is possible to appropriately use, for example, conventionally known solution application means such as spin coating, doctor blade, applicator, comma coater, screen printing method, slit coating, reverse coating, dip coating, curtain coating, and slit die coating.

The diamines constituting the polyamic acid are not particularly limited, and aromatic diamines, aliphatic diamines, alicyclic diamines and the like which are usually used for polyimide synthesis can be used. From the viewpoint of the heat resistance, aromatic diamines are preferable, and among the aromatic diamines, aromatic diamines having a benzoxazole structure are more preferable. When aromatic diamines having a benzoxazole structure are used, a high elastic modulus, low heat shrinkability, and a low coefficient of linear thermal expansion as well as the high heat resistance can be exerted. The diamines can be used singly or in combination of two or more kinds thereof.

The aromatic diamines having a benzoxazole structure are not particularly limited, and examples thereof include: 5-amino-2-(p-aminophenyl)benzoxazole; 6-amino-2-(p-aminophenyl)benzoxazole; 5-amino-2-(m-aminophenyl)benzoxazole; 6-amino-2-(m-aminophenyl)benzoxazole; 2,2'-p-phenylenebis(5-aminobenzoxazole); 2,2'-p-phenylenebis(6-aminobenzoxazole); 1-(5-aminobenzoxazolo)-4-(6-aminobenzoxazolo)benzene; 2,6-(4,4'-diaminodiphenyl)benzo[1,2-d:5,4-d']bisoxazole; 2,6-(4,4'-diaminodiphenyl)benzo[1,2-d:4,5-d']bisoxazole; 2,6-(3,4'-diaminodiphenyl)benzo[1,2-d:5,4-d']bisoxazole; 2,6-(3,4'-diaminodiphenyl)benzo[1,2-d:4,5-d']bisoxazole; 2,6-(3,3'-diaminodiphenyl)benzo[1,2-d:5,4-d']bisoxazole; and 2,6-(3,3'-diaminodiphenyl)benzo[1,2-d:4,5-d']bisoxazole. The aromatic diamines having a benzoxazole structure may be used singly or in combination of two or more kinds thereof.

Examples of the aromatic diamines other than the above-described aromatic diamines having a benzoxazole structure include: 2,2'-dimethyl-4,4'-diaminobiphenyl; 1,4-bis[2-(4-aminophenyl)-2-propyl]benzene(bisaniline); 1,4-bis(4-amino-2-trifluoromethylphenoxy)benzene; 2,2'-ditrifluoromethyl-4,4'-diaminobiphenyl; 4,4'-bis(4-aminophenoxy)biphenyl; 4,4'-bis(3-aminophenoxy)biphenyl; bis[4-(3-aminophenoxy)phenyl]ketone; bis[4-(3-aminophenoxy)phenyl]sulfide; bis[4-(3-aminophenoxy)phenyl] sulfone; 2,2-bis[4-(3-aminophenoxy)phenyl]propane; 2,2-bis[4-(3-aminophenoxy)phenyl]-1,1,1,3,3,3-hexafluoropropane; m-phenylenediamine; o-phenylenediamine; p-phenylenediamine; m-aminobenzylamine; p-aminobenzylamine; 3,3'-diaminodiphenylether; 3,4'-diaminodiphenylether; 4,4'-diaminodiphenylether; 3,3'-diaminodiphenylsulfide; 3,3'-diaminodiphenylsulfoxide; 3,4'-diaminodiphenylsulfoxide; 4,4'-diaminodiphenylsulfoxide; 3,3'-diaminodiphenyl sulfone; 3,4'-diaminodiphenyl sulfone; 4,4'-diaminodiphenyl sulfone; 3,3'-diaminobenzophenone; 3,4'-diaminobenzophenone; 4,4'-diaminobenzophenone; 3,3'-diaminodiphenylmethane; 3,4'-diaminodiphenylmethane; 4,4'-diaminodiphenylmethane; bis[4-(4-aminophenoxy)phenyl]methane; 1,1-bis[4-(4-aminophenoxy)phenyl]ethane; 1,2-bis[4-(4-aminophenoxy)phenyl]ethane; 1,1-bis[4-(4-aminophenoxy)phenyl]propane; 1,2-bis[4-(4-aminophenoxy)phenyl]propane; 1,3-bis[4-(4-aminophenoxy)phenyl]propane; 2,2-bis[4-(4-aminophenoxy)phenyl]propane; 1,1-bis[4-(4-aminophenoxy)phenyl]butane; 1,3-bis[4-(4-aminophenoxy)phenyl]butane; 1,4-bis[4-(4-aminophenoxy)phenyl]butane; 2,2-bis[4-(4-aminophenoxy)phenyl]butane; 2,3-bis[4-(4-aminophenoxy)phenyl]butane; 2-[4-(4-aminophenoxy)phenyl]-2-[4-(4-aminophenoxy)-3-methylphenyl]propane; 2,2-bis[4-(4-aminophenoxy)-3-methylphenyl]propane; 2-[4-(4-aminophenoxy)phenyl]-2-[4-(4-aminophenoxy)-3,5-dimethylphenyl]propane; 2,2-bis[4-(4-aminophenoxy)-3,5-dimethylphenyl]propane; 2,2-bis[4-(4-aminophenoxy)phenyl]-1,1,1,3,3,3-hexafluoropropane; 1,4-bis(3-aminophenoxy)benzene; 1,3-bis(3-aminophenoxy)benzene; 1,4-bis(4-aminophenoxy)benzene; 4,4'-bis(4-aminophenoxy)biphenyl; bis[4-(4-aminophenoxy)phenyl]ketone; bis[4-(4-aminophenoxy)phenyl]sulfide; bis[4-(4-aminophenoxy)phenyl]sulfoxide; bis[4-(4-aminophenoxy)phenyl] sulfone; bis[4-(3-aminophenoxy)phenyl]ether; bis[4-(4-aminophenoxy)phenyl]ether; 1,3-bis[4-(4-aminophenoxy)benzoyl]benzene; 1,3-bis[4-(3-aminophenoxy)benzoyl]benzene; 1,4-bis[4-(3-aminophenoxy)benzoyl]benzene; 4,4'-bis[(3-aminophenoxy)benzoyl]benzene; 1,1-bis[4-(3-aminophenoxy)phenyl]propane; 1,3-bis[4-(3-aminophenoxy)phenyl]propane; 3,4'-diaminodiphenylsulfide; 2,2-bis[3-(3-aminophenoxy)phenyl]-1,1,1,3,3,3-hexafluoropropane; bis[4-(3-aminophenoxy)phenyl]methane; 1,1-bis[4-(3-aminophenoxy)phenyl]ethane; 1,2-bis[4-(3-aminophenoxy)phenyl]ethane; bis[4-(3-aminophenoxy)phenyl]sulfoxide; 4,4'-bis[3-(4-aminophenoxy)benzoyl]diphenylether; 4,4'-bis[3-(3-aminophenoxy)benzoyl]diphenylether; 4,4'-bis[4-(4-amino-$\alpha,\alpha$-dimethylbenzyl)phenoxy]benzophenone; 4,4'-bis[4-(4-amino-$\alpha,\alpha$-dimethylbenzyl)phenoxy]diphenyl sulfone; bis[4-{4-(4-aminophenoxy)phenoxy}phenyl] sulfone; 1,4-bis[4-(4-aminophenoxy)phenoxy-$\alpha,\alpha$-dimethylbenzyl]benzene; 1,3-bis[4-(4-aminophenoxy)phenoxy-$\alpha,\alpha$-dimethylbenzyl]benzene; 1,3-bis[4-(4-amino-6-trifluoromethylphenoxy)-$\alpha,\alpha$-dimethylbenzyl]benzene; 1,3-bis[4-(4-amino-6-fluorophenoxy)-$\alpha,\alpha$-dimethylbenzyl]benzene; 1,3-bis[4-(4-amino-6-methylphenoxy)-$\alpha,\alpha$-dimethylbenzyl]benzene; 1,3-bis[4-(4-amino-6-cyanophenoxy)-$\alpha,\alpha$-dimethylbenzyl]benzene; 3,3'-diamino-4,4'-diphenoxybenzophenone; 4,4'-diamino-5,5'-diphenoxybenzophenone; 3,4'-diamino-4,5'-diphenoxybenzophenone; 3,3'-diamino-4-phenoxybenzophenone; 4,4'-diamino-5-phenoxybenzophenone, 3,4'-diamino-4-phenoxybenzophenone; 3,4'-diamino-5'-phenoxybenzophenone; 3,3'-diamino-4,4'-dibiphenoxybenzophenone; 4,4'-diamino-5,5'-dibiphenoxybenzophenone; 3,4'-diamino-4,5'-dibiphenoxybenzophenone; 3,3'-diamino-4-biphenoxybenzophenone; 4,4'-diamino-5-biphenoxybenzophenone; 3,4'-diamino-4-biphenoxybenzophenone; 3,4'-diamino-5'-biphenoxybenzophenone; 1,3-bis(3-amino-4-phenoxybenzoyl)benzene; 1,4-bis(3-amino-4-phenoxybenzoyl)benzene; 1,3-bis(4-amino-5-phenoxybenzoyl)benzene; 1,4-bis(4-amino-5-phenoxybenzoyl)benzene; 1,3-bis(3-amino-4-biphenoxybenzoyl)benzene, 1,4-bis(3-amino-4-biphenoxybenzoyl)benzene; 1,3-bis(4-amino-5-biphenoxybenzoyl)benzene; 1,4-bis(4-amino-5-biphenoxybenzoyl)benzene; and 2,6-bis[4-(4-amino-$\alpha,\alpha$-dimethylbenzyl)phenoxy]benzonitrile. A part or all of hydrogen atoms on an aromatic ring of the above-described aromatic diamines may be substituted with halogen atoms; alkyl groups or alkoxyl groups having 1 to 3 carbon atoms; or cyano groups, and further a part or all of hydrogen atoms of the alkyl groups or alkoxyl groups having 1 to 3 carbon atoms may be substituted with halogen atoms. The aromatic diamines may be used singly or in combination of two or more kinds thereof.

Examples of the aliphatic diamines include: 1,2-diaminoethane; 1,4-diaminobutane; 1,5-diaminopentane; 1,6-diaminohexane; and 1,8-diaminooctane.

Examples of the alicyclic diamines include: 1,4-diaminocyclohexane and 4,4-methylenebis(2,6-dimethylcyclohexylamine).

The total amount of diamines (aliphatic diamines and alicyclic diamines) other than the aromatic diamines is preferably 20% by mass or less, more preferably 10% by mass or less, still more preferably 5% by mass or less of the total amount of all the diamines. In other words, the amount of aromatic diamines is preferably 80% by mass or more, more preferably 90% by mass or more, still more preferably 95% by mass or more of the total amount of all the diamines.

As tetracarboxylic acids constituting the polyamic acid, aromatic tetracarboxylic acids (including anhydrides thereof), aliphatic tetracarboxylic acids (including anhydrides thereof) and alicyclic tetracarboxylic acids (including anhydrides thereof), which are usually used for polyimide synthesis, can be used. Among these, aromatic tetracarboxylic anhydrides and alicyclic tetracarboxylic anhydrides are preferable, aromatic tetracarboxylic anhydrides are more preferable from the viewpoint of the heat resistance, and alicyclic tetracarboxylic acids are more preferable from the viewpoint of light transmittance. In a case where these are acid anhydrides, the acid anhydrides may have one anhydride structure or two anhydride structures in the molecule, but one (dianhydride) having two anhydride structures in the molecule is preferable. The tetracarboxylic acids may be used singly or in combination of two or more kinds thereof.

Examples of the alicyclic tetracarboxylic acids include: alicyclic tetracarboxylic acids such as cyclobutanetetracarboxylic acid; 1,2,4,5-cyclohexanetetracarboxylic acid; 3,3',4,4'-bicyclohexyltetracarboxylic acid; and anhydrides thereof. Among these, dianhydrides having two anhydride structures (for example, cyclobutanetetracarboxylic dianhydride, 1,2,4,5-cyclohexanetetracarboxylic dianhydride, 3,3',4,4'-bicyclohexyltetracarboxylic dianhydride and the like) are suitable. Incidentally, the alicyclic tetracarboxylic acids may be used singly or in combination of two or more kinds thereof.

For obtaining high transparency, the amount of the alicyclic tetracarboxylic acids is, for example, preferably 80% by mass or more, more preferably 90% by mass or more, still more preferably 95% by mass or more of the total amount of all the tetracarboxylic acids.

The aromatic tetracarboxylic acids are not particularly limited, but a pyromellitic acid residue (namely, one having a structure derived from pyromellitic acid) is preferable, and an anhydride thereof is more preferable. Examples of such aromatic tetracarboxylic acids include: pyromellitic dianhydride; 3,3',4,4'-biphenyltetracarboxylic dianhydride; 4,4'-oxydiphthalic dianhydride; 3,3',4,4'-benzophenonetetracarboxylic dianhydride; 3,3',4,4'-diphenylsulfonetetracarboxylic dianhydride; 2,2-bis[4-(3,4-dicarboxyphenoxy)phenyl]propionic anhydride; and 4,4'-(2,2-hexafluoroisopropyridene)diphthalic dianhydride.

For obtaining high heat resistance, the amount of the aromatic tetracarboxylic acids is, for example, preferably 80% by mass or more, more preferably 90% by mass or more, still more preferably 95% by mass or more of the total amount of all the tetracarboxylic acids.

It may be preferable that the polyimide-based resin is transparent depending on the application. Examples of acid components used in the synthesis of the precursor thereof include 1,2,3,4-cyclobutanetetracarboxylic dianhydride; 1,2,4,5-cyclopentanetetracarboxylic dianhydride; 1,2,4,5-cyclohexanetetracarboxylic dianhydride; bicyclo[2,2,1]heptane-2,3,5,6-tetracarboxylic dianhydride; bicyclo[2,2,2]octane-2,3,5,6-tetracarboxylic dianhydride; 3,3',4,4'-bicyclohexyltetracarboxylic dianhydride; and 1,2,4-cyclohexanetricarboxylic anhydride. Particularly preferred are 1,2,3,4-cyclobutanetetracarboxylic dianhydride, 1,2,4,5-cyclohexanetetracarboxylic dianhydride, and 3,3',4,4'-bicyclohexyltetracarboxylic dianhydride. These alicyclic carboxylic acids may be used singly or in combination of two or more kinds thereof. Meanwhile, those containing unsaturated bonds such as bicyclo[2,2,2]octo-7-ene-2,3,5,6-tetracarboxylic dianhydride tend to be colored at the time of heat treatment and deteriorate the optical properties of the film, and thus are not preferable from the viewpoint of transparency.

Examples of the diamine component used in the synthesis of the transparent polyimide-based resin or the precursor thereof include aromatic diamines such as 1,3-phenylenediamine, 1,4-phenylenediamine, 2,4-diaminotoluene, 2,6-diaminotoluene, 3,4-diaminotoluene, 4,5-dimethyl-1,2-phenylenediamine, 2,5-dimethyl-1,4-phenylenediamine, 2,6-dimethyl-1,4-phenylenediamine, 2,3,5,6-tetramethyl-1,4-phenylenediamine, 3-aminobenzylamine, m-xylylenediamine, p-xylylenediamine, 1,5-diaminonaphthalene, 2,2'-dimethylbiphenyl-4,4'-diamine, 2,2'-bis(trifluoromethyl)benzidine, 3,3'-dimethoxybenzidine, 4,4'-diaminooctafluorobiphenyl, 3,3'-diaminodiphenylmethane, 3,4'-diaminodiphenylmethane, 4,4'-diaminodiphenylmethane, 4,4'-methylenebis(2,6-diethylaniline), 4,4'-methylenebis(2-ethyl-6-methylaniline), 4,4'-ethylenedianiline, 4,4'-diaminodiphenyl ether, 3,4'-diaminodiphenyl ether, 3,3'-diaminodiphenyl ether, 2,2'-bis(trifluoromethyl)-4,4'-diaminodiphenyl ether, 1,3-bis(4-aminophenoxy)benzene, 1,3-bis(3-aminophenoxy)benzene, 1,4-bis(4-aminophenoxy)benzene, 1,4-bis(4-amino-2-trifluoromethylphenoxy)benzene, 4,4'-bis(4-aminophenoxy)biphenyl, 4,4'-diamino-3,3'-dimethyldiphenylmethane, bis[4-(4-aminophenoxy)phenyl] sulfone, bis[4-(3-aminophenoxy)phenyl] sulfone, 2,2-bis(4-aminophenyl)hexafluoropropane, 2,2-bis(3-aminophenyl)hexafluoropropane, 2,2'-bis[4-(4-aminophenoxy)phenyl]propane, 2,2'-bis[4-(4-aminophenoxy)phenyl]hexafluoropropane, 2,2-bis(3-amino-4-methylphenyl)hexafluoropropane, $\alpha,\alpha'$-bis(4-aminophenyl)-1,4-diisopropylbenzene, bis(2-aminophenyl) sulfide, bis(4-aminophenyl) sulfide, 3,3'-diaminodiphenyl sulfone, 4,4'-diaminodiphenyl sulfone, 4,4'-diaminodiphenyl sulfide, 4,4'-diaminobenzophenone, 3,3'-diaminobenzophenone, 4,4'-diaminobenzanilide, 1,4-bis(4-aminophenoxy)benzene, bis(4-aminophenyl) terephthalate, 2,7-diaminofluorene, and 9,9-bis(4-aminophenyl)fluorene as a diamine compound. Examples thereof include 1,3-diaminocyclohexane, 1,4-diaminocyclohexane, 1,3-bis(aminomethyl)cyclohexane, 1,1-bis(4-aminophenyl)cyclohexane, 4,4'-diaminodicyclohexylmethane, 4,4'-methylenebis(2-methylcyclohexylamine), 4,4'-methylenebis(2,6-dimethylcyclohexylamine), 4,4'-diaminodicyclohexylpropane, bicyclo[2.2.1]heptane-2,3-diamine, bicyclo[2.2.1]heptane-2,5-diamine, bicyclo[2.2.1]heptane-2,6-diamine, bicyclo[2.2.1]heptane-2,7-diamine, 2,3-bis(aminomethyl)-bicyclo[2.2.1]heptane, 2,5-bis(aminomethyl)-bicyclo[2.2.1]heptane, 2,6-bis(aminomethyl)-bicyclo[2.2.1]heptane, 3(4),8(9)-bis(aminomethyl)tricyclo[5.2.1.0 2,6)]decane as an alicyclic diamine. Among these, particularly preferred are p-phenylenediamine, 2,2'-dimethylbiphenyl-4,4'-diamine, 2,2'-bis(trifluoromethyl)benzidine, 2,2'-bis(trifluoromethyl)-4,4'-diaminodiphenyl ether, 1,4-bis(4-amino-2-trifluoromethylphenoxy)benzene, 1,4-diaminocyclohexane, 4,4'-diaminodicyclohexylmethane, 4,4'-methylenebis(2-methylcyclohexylamine), and 4,4'-methylenebis (2,6-dimethylcyclohexylamine). The amine components may be used singly or in combination of two or more kinds thereof.

The thickness of the polymer film is preferably 3 $\mu$m or more, more preferably 11 $\mu$m or more, still more preferably 24 $\mu$m or more, yet still more preferably 45 $\mu$m or more. The upper limit of the thickness of the polymer film is not particularly limited but is preferably 250 $\mu$m or less, more preferably 150 $\mu$m or less, still more preferably 90 $\mu$m or less for use as a flexible electronic device.

The average CTE of the polymer film at between 30°C and 300°C is preferably -5 ppm/°C to +20 ppm/°C, more preferably -3 ppm/°C to +15 ppm/°C, still more preferably - 1 ppm/°C to +10 ppm/°C. When the CTE is in the above range, a small difference in coefficient of linear thermal expansion between the polymer film and a general support (inorganic substrate) can be maintained, and the polymer film and the inorganic substrate can be prevented from peeling off from each other when being subjected to a process of applying heat as well. Here, CTE is a factor that represents reversible expansion and contraction with respect to temperature. The CTE of the polymer film refers to the average value of the CTE in the machine direction (MD direction) and the CTE in the transverse direction (TD direction) of the polymer film.

The method for measuring the CTE of the polymer film is as described in Examples.

It is preferable that the heat-resistant polymer film is subjected to a surface activation treatment. By the surface activation treatment, the surface of the heat-resistant polymer film is modified to a state (so-called activated state) in which a functional group is present, and the affinity for the adhesive is improved.

The surface activation treatment in the present specification is a dry or wet surface treatment. As the dry surface treatment, a treatment in which the surface is irradiated with active energy rays such as ultraviolet rays, electron beams, and X rays, a corona treatment, a vacuum plasma treatment, a normal-pressure plasma treatment, a flame treatment, an ITRO treatment and the like can be used. Examples of the wet surface treatment include a treatment in which the film surface is brought into contact with an acid or alkali solution. The surface activation treatment preferably used is a plasma treatment and a combination of a plasma treatment and a wet acid treatment.

The plasma treatment is not particularly limited, but there are an RF plasma treatment in a vacuum, a microwave plasma treatment, a microwave ECR plasma treatment, an atmospheric-pressure plasma treatment, and a corona treatment, and the plasma treatment also includes a gas treatment containing fluorine, an ion injection treatment using an ion source, a treatment using the PBII method, a flame treatment in which the film surface is exposed to a thermal plasma, and an ITRO treatment. Among these, an RF plasma treatment in a vacuum, a microwave plasma treatment, and an atmospheric-pressure plasma treatment are preferable.

As suitable conditions for the plasma treatment, treatments with plasmas known to have a high etching effect such as an oxygen plasma and a plasma containing fluorine such as $CF_4$ and $C_2F_6$ or plasmas, which have a high effect of applying physical energy to the polymer surface and physically etching the polymer surface, such as Ne, Ar, Kr, Xe, and plasma are desirable. It is also preferable to add plasmas such as $CO_2$, CO, $H_2$, $N_2$, $NH_4$, and $CH_4$, any mixed gas thereof, and water vapor. In addition to these, it is preferable to prepare a plasma containing at least one or more components selected from the group consisting of OH, $N_2$, N, CO, $CO_2$, H, $H_2$, $O_2$, NH, $NH_2$, $NH_3$, COOH, NO, $NO_2$, He, Ne, Ar, Kr, Xe, $CH_2O$, Si $(OCH_3)_4$, $Si(OC_2H_5)_4$, $C_3H_7Si(OCH_3)_3$, and $C_3H_7Si(OC_2H_5)_3$ as a gas or as a decomposition product in the plasma. In the case of aiming for a treatment in a short time, a plasma having a high energy density and high kinetic energy of ions in the plasma and a plasma having a high number density of active species are desirable, but there is a limit to the increase in energy density since surface smoothness is required. When an oxygen plasma is used, it is preferable in that surface oxidation proceeds and an OH group is generated, but a surface that already has poor close contact force to the film itself is likely to be formed, the surface roughness (roughness) becomes large, and thus the close contact property also deteriorates.

In a plasma using Ar gas, the surface is affected by purely physical collision, and the surface roughness becomes large in this case as well. Considering all of these, a microwave plasma treatment, a microwave ECR plasma treatment, plasma irradiation with an ion source that makes it easy to knock high energy ions, the PBII method and the like are also desirable.

In the surface activation treatment, the polymer surface is cleaned and an active functional group is generated. The generated functional group is bound to the coupling agent layer by a hydrogen bond or a chemical reaction, and the heat-resistant polymer film layer and the coupling agent layer can be firmly bonded to each other.

In the plasma treatment, the effect of etching the surface of the heat-resistant polymer film can also be obtained. In particular, in a heat-resistant polymer film containing a relatively large amount of lubricant particles, protrusions due to the lubricant may hinder the adhesion between the films. In this case, when the surface of the heat-resistant polymer film is thinly etched by a plasma treatment to expose some of the lubricant particles and then a treatment with hydrofluoric acid is performed, it is possible to remove the lubricant particles near the film surface.

The heat shrinkage rate of the polymer film at between 30°C and 500°C is preferably ± 0.9%, still more preferably ± 0.6%. The heat shrinkage rate is a factor that represents irreversible expansion and contraction with respect to the temperature.

The tensile breaking strength of the polymer film is preferably 60 MPa or more, more preferably 120 MP or more, still more preferably 240 MPa or more. The upper limit of the tensile breaking strength is not particularly limited but is practically less than about 1000 MPa. When the tensile breaking strength is 60 MPa or more, it is possible to prevent the polymer film from breaking when being peeled off from the inorganic substrate. The tensile breaking strength of the polymer film refers to the average value of the tensile breaking strength in the machine direction (MD direction) and the tensile breaking strength in the transverse direction (TD direction) of the polymer film. The method for measuring the tensile breaking strength of the polymer film is as described in Examples.

The tensile breaking elongation of the polymer film is preferably 1% or more, more preferably 5% or more, still more preferably 20% or more. When the tensile breaking elongation is 1% or more, the handleability is excellent. The tensile breaking elongation of the polymer film refers to the average value of the tensile breaking elongation in the machine direction (MD direction) and the tensile breaking elongation in the transverse direction (TD direction) of the polymer film. The method for measuring the tensile breaking elongation of the polymer film is as described in Examples.

The tensile elasticity of the polymer film is preferably 3 GPa or more, more preferably 6 GPa or more, still more preferably 8 GPa or more. When the tensile elasticity is 3 GPa or more, the polymer film is less expanded and deformed when being peeled off from the inorganic substrate and exhibits excellent handleability. The tensile elasticity is preferably 20 GPa or less, more preferably 12 GPa or less, still more preferably 10 GPa or less. When the tensile elasticity is 20 GPa or less, the polymer film can be used as a flexible film. The tensile elasticity of the polymer film refers to the average value of the tensile elasticity in the machine direction (MD direction) and the tensile elasticity in the transverse direction (TD direction) of the polymer film. The method for measuring the tensile elasticity of the polymer film is as described in Examples.

Unevenness of the thickness of the polymer film is preferably 20% or less, more preferably 12% or less, still more preferably 7% or less, particularly preferably 4% or less. When the evenness of the thickness exceeds 20%, the polyimide film tends to be hardly applied to a narrow part. Incidentally, unevenness of the thickness of a film can be determined based on the following equation from film thicknesses, which are measured at about 10 randomly extracted points of a film to be measured by using, for example, a contact-type film thickness meter.

$$\texttt{Unevenness of thickness of film (\%)}$$
$$\texttt{= 100 × (maximum film thickness - minimum film}$$
$$\texttt{thickness) ÷ average film thickness}$$

The polymer film is preferably obtained in the form of being wound as a long polymer film having a width of 300 mm or more and a length of 10 m or more at the time of production, more preferably in the form of a roll-shaped polymer film wound around a winding core. When the polymer film is wound in a roll shape, it is easy to transport the polymer film in the form of a heat-resistant polymer film wound in a roll shape. When the polymer film is wound in a roll shape, both ends of the polymer film may or may not be slit. It is preferable to slit the ends, and the width of the polymer film in the case of slitting the ends is preferably 90 mm or more.

In order to secure handleability and productivity of the polymer film, a lubricant (particles) having a particle size of about 10 to 1000 nm is preferably added to/contained in the polymer film at about 0.03% to 3% by mass to impart fine unevenness to the surface of the polymer film and secure slipperiness.

It makes it possible to fabricate the heat-resistant polymer film, which is rectangular, has an area of 0.65 $m^2$ or more, and has a side of at least 700 mm or more. The upper limit of the length of one side is not particularly limited, and examples thereof include 3000 mm or less and 2000 mm or less.

According to the apparatus for manufacturing a laminate 10, the bonding can be performed in a state in which at least a part of the silane coupling agent is dissolved in the aqueous medium, and it is thus possible to have uniform adhesive strength when the heat-resistant polymer film is large (is rectangular, has an area of 0.65 $m^2$ or more, and has a side of at least 700 mm or more) as well.

The surface activation treatment described in the first embodiment may be performed on the first heat-resistant polymer film or the second heat-resistant polymer film. The surface activation treatment may be performed only on one surface of each heat-resistant polymer film or on both surfaces. In the case of performing the plasma treatment on one surface, the plasma treatment can be performed only on the surface, which is not in contact with the electrode, of the heat-resistant polymer film by placing the heat-resistant polymer film on the electrode on one side to be in contact with the electrode in the plasma treatment using a parallel-plate electrode. The plasma treatment can be performed on both surfaces by placing the heat-resistant polymer film to be in a state of being electrically floated in the space between the two electrodes. The treatment can be performed on one surface by performing the plasma treatment in a state in which a protective film is glued to one surface of the heat-resistant polymer film. As the protective film, a PET film or olefin film with adhesive, or the like can be used.

The inorganic substrate is only required to be a plate-shaped substrate that can be used as a substrate formed of an inorganic substance, and examples thereof include those mainly composed of glass plates, ceramic plates, semiconductor wafers, metals and the like and those in which these glass plates, ceramic plates, semiconductor wafers, and metals are laminated, those in which these are dispersed, and those in which fibers of these are contained as the composite of these.

In the present embodiment, an inorganic substrate, which does not contain nitrogen as a constituent element, is preferably used.

Examples of the glass plates include quartz glass, high silicate glass (96% silica), soda lime glass, lead glass, aluminoborosilicate glass, and borosilicate glass (Pyrex (registered trademark)), borosilicate glass (alkali-free), borosilicate glass (microsheet), aluminosilicate glass and the like. Among these, those having a coefficient of linear thermal expansion of 5 ppm/K or less are desirable, and in the case of a commercially available product, "Corning (registered trademark) 7059", "Corning (registered trademark) 1737", and "EAGLE" manufactured by Corning Inc., "AN100" manufactured by AGC Inc., "OA10" and "OA11" manufactured by Nippon Electric Glass Co., Ltd., "AF32" manufactured by SCHOTT AG, and the like that are glass for liquid crystals are desirable.

The semiconductor wafer is not particularly limited, but examples thereof include a silicon wafer and wafers of germanium, silicon-germanium, gallium-arsenide, aluminum-gallium-indium, nitrogen-phosphorus-arsenic-antimony, SiC, InP (indium phosphide), InGaAs, GaInNAs, LT, LN, ZnO (zinc oxide), CdTe (cadmium telluride), ZnSe (zinc selenide) and the like. Among these, the wafer preferably used is a silicon wafer, and a mirror-polished silicon wafer having a size of 8 inches or more is particularly preferable.

The metals include single element metals such as W, Mo, Pt, Fe, Ni, and Au, alloys such as Inconel, Monel, Nimonic, carbon-copper, Fe-Ni-based Invar alloy, and Super Invar alloy, and the like. Multilayer metal plates formed by adding another metal layer or a ceramic layer to these metals are also included. In this case, when the overall coefficient of linear thermal expansion (CTE) with the additional layer is low, Cu, Al and the like are also used in the main metal layer. The metals used as the addition metal layer is not limited as long as they are those that strengthen the close contact property with the polymer film, those that have properties that there is no diffusion and the chemical resistance and heat resistance are favorable, but suitable examples thereof include Cr, Ni, TiN, and Mo-containing Cu.

It is desirable that the planar portion of the inorganic substrate is sufficiently flat. Specifically, the P-V value of the surface roughness is 50 nm or less, more preferably 20 nm or less, still more preferably 5 nm or less. When the surface is coarser than this, the adhesive strength between the polymer film layer and the inorganic substrate may be insufficient.

The thickness of the inorganic substrate is not particularly limited, but a thickness of 10 mm or less is preferable, a thickness of 3 mm or less is more preferable, and a thickness of 1.3 mm or less is still more preferable from the viewpoint of handleability. The lower limit of the thickness is not particularly limited, but is preferably 0.05 mm or more, more preferably 0.3 mm or more, still more preferably 0.5 mm or more.

The silane coupling agent has an action of being physically or chemically interposed between the inorganic substrate and the polymer film and bonding the inorganic substrate and the polymer film to each other.

The silane coupling agent used in the present embodiment is not particularly limited, but preferably contains a coupling agent having an amino group.

Preferred specific examples of the silane coupling agent include N-2-(aminoethyl)-3-aminopropylmethyldimethoxysilane, N-2-(aminoethyl)-3-aminopropyltrimethoxysilane, N-2-(aminoethyl)-3-aminopropyltriethoxysilane, 3-aminopropyltrimethoxysilane, 3-aminopropyltriethoxysilane, 3-triethoxysilyl-N-(1,3-dimethyl-butylidene)propylamine, N-phenyl-3-aminopropyltrimethoxysilane, N-(vinylbenzyl)-2-aminoethyl-3-aminopropyltrimethoxysilane hydrochloride, aminophenyltrimethoxysilane, aminophenethyltrimethoxysilane, and aminophenylaminomethylphenethyltrimethoxysilane.

Among the silane coupling agents, a silane coupling agent having one silicon atom in one molecule is particularly preferable, and examples thereof include N-2-(aminoethyl)-3-aminopropylmethyldimethoxysilane, N-2-(aminoethyl)-3-aminopropyltrimethoxysilane, N-2-(aminoethyl)-3-aminopropyltriethoxysilane, 3-aminopropyltrimethoxysilane, 3-aminopropyltriethoxysilane, 3-triethoxysilyl-N-(1,3-dimethyl-butylidene)propylamine, aminophenyltrimethoxysilane, aminophenethyltrimethoxysilane, and aminophenylaminomethylphenethyltrimethoxysilane. When particularly high heat resistance is required in the process, a silane coupling agent, in which an aromatic group links Si and an amino group to each other via, is desirable.

Another coupling agent can be used together with the silane coupling agent. Examples of the coupling agent include 11-amino-1-undecenethiol.

In the present embodiment, a diamine can be used as a reactive liquid together with the silane coupling agent. Diamine compounds can be used singly or a plurality of these can be used in combination. Diamine compounds can also be used as solutions of alcohols, water, and various solvents. A diamine in the form of a solution may be mixed with a reactive liquid other than a diamine.

Examples of the diamine, which can be used in the present embodiment, include 1,4-butanediamine, 1,5-pentanediamine, 1,6-hexanediamine, 1,7-heptanediamine, 1,8-octanediamine, 1,9-nonanediamine, 1,10-decanediamine, 1,2-hexanediamine, 1,3-hexanediamine, 1,4-hexanediamine, 1,5-hexanediamine, 1,2-pentanediamine, 1,3-pentanediamine, and 1,4-pentanediamine.

As the method for applying a silane coupling agent (method for forming a silane coupling agent layer), a method in which a silane coupling agent solution is applied to the inorganic substrate, a vapor deposition method, and the like can be used. The silane coupling agent layer may be formed on the surface of the heat-resistant polymer film. The application of the silane coupling agent can be performed using the coating device 40.

As the method for applying a silane coupling agent solution, it is possible to use a solution of a silane coupling agent diluted with a solvent such as an alcohol and to appropriately use conventionally known solution application means (conventionally known coating devices) such as a spin coating method, a curtain coating method, a dip coating method, a slit die coating method, a gravure coating method, a bar coating method, a comma coating method, an applicator method, a screen printing method, and a spray coating method.

The silane coupling agent layer can also be formed by a vapor deposition method, and is specifically formed by exposing the inorganic substrate to the vapor of a silane coupling agent, namely, a silane coupling agent in a substantially gaseous state. The vapor of a silane coupling agent can be obtained by heating the silane coupling agent in a liquid state at a temperature of 40°C to about the boiling point of the silane coupling agent. The boiling point of silane coupling agents varies depending on the chemical structure, but is generally in a range of 100°C to 250°C. However, heating to 200°C or more is not preferable since a side reaction on the organic group side of the silane coupling agent may be caused.

The environment for heating a silane coupling agent may be under any of raised pressure, normal pressure, or reduced pressure but is preferably under normal pressure or reduced pressure in the case of promoting the vaporization of the silane coupling agent. Since a large number of silane coupling agents are flammable liquids, it is preferable to perform the vaporization work in a closed container, preferably after purging the interior of the container with an inert gas.

The time for exposing the inorganic substrate to a silane coupling agent is not particularly limited, but is preferably within 20 hours, more preferably within 60 minutes, still more preferably within 15 minutes, most preferably within 1 minute.

The temperature of the inorganic substrate during exposure of the inorganic substrate to a silane coupling agent is preferably controlled to an appropriate temperature between -50°C and 200°C depending on the kind of silane coupling agent and the desired thickness of the silane coupling agent layer.

The film thickness of the silane coupling agent layer is extremely thinner compared to those of the inorganic substrate, polymer film and the like, is a thickness negligible from the viewpoint of mechanical design, and is only required to be minimum a thickness in the monomolecular layer order in principle. Generally, the film thickness is less than 20 nm, preferably 15 nm or less, and practically, preferably 10 nm or less, more preferably 7 nm or less, still more preferably 5 nm or less. However, when the film thickness is mathematically in a region of 5 nm or less, the silane coupling agent layer may exist in the form of a cluster rather than as a uniform coating film. The film thickness of the silane coupling agent layer can be calculated by the ellipsometry method or from the concentration of the silane coupling agent solution at the time of coating and the applied amount.

As the aqueous medium, water or a mixed medium of water and a water-soluble solvent can be used. As the water-soluble solvent, lower alcohols, low-molecular-weight ketones, tetrahydrofuran, and the like can be used. Aqueous mediums preferably used are pure water, a mixed solvent of water and methanol, a mixed solvent of water and ethanol, a mixed solvent of water, isopropanol, and methyl ethyl ketone, a mixed solvent of water and tetrahydrofuran, and the like. Aqueous mediums particularly preferably used in the present invention are water; monohydric alcohols, dihydric alcohols, and trihydric alcohols, which are liquid at room temperature; or mixtures containing two or more components among these. A trace amount of surfactant may be added to the aqueous medium in order to improve the wettability between the aqueous medium and the inorganic substrate or polymer film.

The aqueous medium is used to wet the opposing surfaces at the time of bonding, namely, the bonding surfaces. As the method for wetting the bonding surface of the substrate or film with an aqueous medium, existing methods can be applied, such as dropping with a dropper or dispenser, discharging from a valve, or spraying from a spray nozzle in the form of mist. Immersing the substrate or film in an aqueous medium is also an effective means for wetting. Examples of the method for wetting the bonding surface of the substrate or film with an aqueous medium include a method in which wetting is performed using the water supply device 50.

In the case of using a liquid containing water or an alcohol as the aqueous medium, the liquid also contributes to the promotion of the reaction of silane coupling agent.

As a method for bonding the substrate and the film to each other, a pressing method, a roll lamination method, and the like can be adopted. For example, pressurization can be performed in a planar or linear manner by pressing, lamination, or roll lamination in an atmosphere at the atmospheric pressure or in a vacuum. The process can also be promoted by performing heating during pressurization. In the present invention, pressing or roll lamination in the atmospheric air atmosphere is preferable, and particularly a method using a roll (roll lamination or the like) is preferable since bonding can be performed while sequentially extruding the aqueous medium at the bonding interface from the bonding surface.

A method may be mentioned in which the inorganic substrate after being supplied with an aqueous medium and the heat-resistant polymer film are bonded to each other using the laminating device 70.

A functional element is formed on a surface on the opposite side to the bonding surface of the heat-resistant polymer film of the laminate, and the polymer film is peeled off from the substrate together with the functional element after formation, whereby a flexible electronic device can be fabricated.

In the present specification, the electronic device refers to a wiring board which carries out electrical wiring and has a single-sided, double-sided, or multilayered structure, electronic circuits including active devices such as transistors and diodes and passive devices such as resistors, capacitors, and inductors, sensor elements which sense pressure, temperature, light, humidity and the like, biosensor elements, light emitting elements, image display elements such as liquid crystal displays, electrophoresis displays, and self-luminous displays, wireless and wired communication elements, arithmetic elements, storage elements, MEMS elements, solar cells, thin film transistors, and the like.

In the method for manufacturing a flexible electronic device in the present specification, an electronic device is formed on the polymer film surface of a laminate fabricated by the above-described method and then the polymer film is peeled off from the inorganic substrate.

The method for peeling off the polymer film, on which an electronic device is formed, from the inorganic substrate is not particularly limited, but a method in which the polymer film is stripped off from the end with tweezers and the like, a method in which a cut is made into the polymer film, a pressure sensitive adhesive tape is pasted to one side of the cut portion, and then the polymer film is stripped off from the tape portion, a method in which one side of the cut portion of the polymer film is vacuum-adsorbed and then the polymer film is stripped off from that portion, and the like can be adopted. When the cut portion of the polymer film is bent with a small curvature during peeling off, stress may be applied to the device at that portion and the device may be destroyed, and it is thus desirable to peel off the polymer film in the state of having a curvature as large as possible. For example, it is desirable to strip off the polymer film while winding the polymer film on a roll having a large curvature or to strip off the polymer film using a machine having a configuration in which the roll having a large curvature is located at the peeling portion.

As the method for making a cut into the polymer film, there are a method in which the polymer film is cut with a cutting tool such as a cutter, a method in which the polymer film is cut by scanning a laser and the laminate relative to each other, a method in which the polymer film is cut by scanning a water jet and the laminate relative to each other, a method in which the polymer film is cut while being cut a little to the glass layer by a dicing apparatus for a semiconductor chip, and the like, but the method is not particularly limited. For example, when employing the above-described methods, it is also possible to appropriately employ a technique in which ultrasonic waves are superimposed on the cutting tool or a reciprocating motion, a vertical motion and the like are further added to improve the cutting performance.

It is also useful to stick another reinforcing base material to the portion to be peeled off in advance and peel off the polymer film together with the reinforcing base material. In a case where the flexible electronic device to be peeled off is the backplane of a display device, it is also possible to obtain a flexible display device by sticking the frontplane of the display device in advance, integrating these on an inorganic substrate, and then peeling off these two at the same time.

The apparatus for manufacturing a laminate and the method for manufacturing a laminate according to the first embodiment have been described above.

Next, the apparatus for manufacturing a laminate roll and the method for manufacturing a laminate roll according to the second embodiment will be described.

[Second embodiment]

The apparatus for manufacturing a laminate roll according to the second embodiment has the following configurations.

(1) An apparatus for manufacturing a laminate roll, the apparatus including:

a metal foil transporting device for transporting a metal foil;
a water supply device for supplying an aqueous medium to a surface of a metal foil coated with a silane coupling agent and/or a surface of a heat-resistant polymer film coated with a silane coupling agent; and
a roll laminating device for bonding the metal foil and the heat-resistant polymer film, of which either or both have been supplied with the aqueous medium, to each other.

(2) The apparatus for manufacturing a laminate roll according to (1), which includes a coating device for coating a metal foil with a silane coupling agent.

(3) The apparatus for manufacturing a laminate roll according to (1) or (2), which includes a metal foil cleaning device for cleaning a metal foil before being supplied with an aqueous medium.

(4) The apparatus for manufacturing a laminate roll according to any one of (1) to (3), which includes a film cleaning device for cleaning a heat-resistant polymer film before being supplied with an aqueous medium.

(5) The apparatus for manufacturing a laminate roll according to any one of (1) to (4), in which the heat-resistant polymer film has a width of 700 mm or more.

(6) The apparatus for manufacturing a laminate roll according to any one of (1) to (5), in which a pressing pressure of the roll laminating device is 0.5 MPa or less.

The method for manufacturing a roll of a laminate according to the second embodiment has the following configurations.

> (7) A method for manufacturing a laminate roll, which is a method for manufacturing a roll of a laminate of a metal foil and a heat-resistant polymer film, the method including:
>
>> a step A of supplying an aqueous medium to a surface of a metal foil coated with a silane coupling agent and/or a surface of a heat-resistant polymer film coated with a silane coupling agent; and
>> a step B of bonding the metal foil and the heat-resistant polymer film, of which either or both have been supplied with the aqueous medium, to each other.
>
> (8) The method for manufacturing a laminate roll according to (7), which includes a step X-1 of coating a metal foil with a silane coupling agent before the step A.
> (9) The method for manufacturing a laminate roll according to (7) or (8), which includes a step X-2 of cleaning a metal foil before the step A.
> (10) The method for manufacturing a laminate roll according to any one of (7) to (9), which includes a step X-3 of cleaning a heat-resistant polymer film before the step A.
> (11) The method for manufacturing a laminate roll according to any one of (7) to (10), which includes a step X-4 of inspecting appearance of a laminate roll of a metal foil and a heat-resistant polymer film, which have been bonded to each other, after the step B.
> (12) The method for manufacturing a laminate roll according to (11), which includes a step X-5 of peeling off a heat-resistant polymer film from a laminate roll judged to have poor appearance in the step X-4.
> (13) The method for manufacturing a laminate roll according to any one of (7) to (12), in which a pressing pressure in a step B is 0.5 MPa or less.

In the second embodiment, the "metal foil" corresponds to the "first sheet" in the present embodiment, the "metal foil transporting device" corresponds to the "first sheet transporting device" in the present embodiment, the "heat-resistant polymer film" corresponds to the "second sheet" in the present embodiment, the "roll laminating device" corresponds to the "laminating device" in the present embodiment, the "apparatus for manufacturing a laminate roll" corresponds to the "apparatus for manufacturing a laminate" in the present embodiment, the "metal foil cleaning device" corresponds to the "first cleaning device" in the present embodiment, and the "film cleaning device" corresponds to the "second cleaning device" in the present embodiment.

Hereinafter, the apparatus for manufacturing a laminate roll and the method for manufacturing a laminate roll according to the second embodiment will be specifically described.

Fig. 2 is a schematic diagram for explaining the apparatus for manufacturing a laminate roll according to the second embodiment. The same reference numerals are given to the configurations common to the apparatus for manufacturing a laminate 10 according to the first embodiment.

As illustrated in Fig. 2, an apparatus for manufacturing a laminate roll 1000 according to the second embodiment includes a device having a function of unwinding a metal foil from a metal foil 200 and transporting the metal foil, a metal foil cleaning device 30, a coating device 40, a water supply device 50, a device having a function of unwinding a film from a film roll 300 and transporting the film, a film cleaning device 60, a roll laminating device 70, an appearance inspecting device 80, and a winding device for finally winding a laminate into a laminate roll 400. However, the apparatus for manufacturing a laminate in the present invention is only required to include at least a device for transporting the first sheet (metal foil), a water supply device, and a roll laminating device.

A metal foil 100 is unwound from the metal foil 200, transported, and moved between the respective devices included in the apparatus for manufacturing a laminate roll 1000. The metal foil transportation is not particularly limited as long as it is possible to transport the metal foil 100, but it is desirable that the metal foil transportation can automate the manufacture of a laminate.

The metal foil cleaning device 30 includes a cleaning liquid spray nozzle 32, an air knife (not illustrated), and the like. The metal foil cleaning device 30 can spray a cleaning liquid 34 onto the metal foil 100 and then dry the surface of the metal foil 100 by blowing air on the surface using the air knife. The first cleaning device (metal foil cleaning device) according to the present invention is not limited to the above-described metal foil cleaning device 30 as long as it can preferably continuously clean the first sheet (metal foil) before being supplied with an aqueous medium, and conventionally known ones can be adopted.

The coating device 40 includes a silane coupling agent supply pipe 42 provided with a plurality of small holes, and the like. The coating device 40 can coat the metal foil 100 with a silane coupling agent 44 from the silane coupling agent supply pipe 42. The coating device according to the present invention is not limited to the above-described coating device 40 as long as it can coat the metal foil with a silane coupling agent, and conventionally known ones can be adopted.

The water supply device 50 supplies an aqueous medium 52 to the surface of the metal foil 100 coated with a silane coupling agent. The configuration of the water supply device 50 is not particularly limited as long as it can supply the aqueous medium 52 to the surface of the metal foil 100 coated with a silane coupling agent, and conventionally known ones can be adopted. The amount of the aqueous medium 52 supplied is not particularly limited, but is preferably about 0.1 to 50 g/100 cm$^2$ from the viewpoint of decreasing bubbles and foreign matters.

The polymer film is unwound from the film roll 300 and guided to the film cleaning device 60. The film cleaning device can clean the surface of a heat-resistant polymer film 102 by spraying a cleaning liquid 64 onto the heat-resistant polymer film 102 supplied from the film roll 300 and then blowing air on the surface using the air knife (not illustrated). The second cleaning device (film cleaning device) according to the present invention is not limited to the above-described film cleaning device 60 as long as it can preferably continuously clean the second sheet (heat-resistant polymer film) before being supplied with an aqueous medium, and conventionally known ones can be adopted.

The roll laminating device 70 includes a laminating roller 72 and the like. The roll laminating device 70 bonds the metal foil 100 and the heat-resistant polymer film 102, which have been supplied with the aqueous medium 52, to each other by performing pressing using the laminating roller 72. The pressing pressure at the time of bonding is preferably 0.5 MPa or less. According to the apparatus for manufacturing a laminate 1000, the bonding can be performed in a state in which at least a part of the silane coupling agent 44 is dissolved in the aqueous medium 52, and thus the pressing pressure at the time of lamination can be lowered. The laminating device (roll laminating device) according to the present invention is not limited to the above-described roll laminating device 70 as long as it can bond the metal foil and the heat-resistant polymer film, which have been supplied with an aqueous medium, to each other, and conventionally known ones can be adopted.

The pressing pressure of the roll laminating device 70 is preferably 0.5 MPa or less. Since the bonding can be performed in a state in which at least a part of the silane coupling agent is dissolved in the aqueous medium, the pressing pressure at the time of lamination can be lowered. When the pressing pressure is 0.5 MPa or less, it is possible to suppress damage to the metal foil.

The lower limit of the pressing pressure is not particularly limited, but is preferably 0.1 MPa or more. When the pressing pressure is 0.1 MPa or more, it is possible to prevent the generation of a portion that is not in close contact and insufficient adhesion. The temperature at the time of pressurization is preferably 10°C to 60°C, more preferably 20°C to 40°C. The aqueous solution may vaporize and generate bubbles and the polymer film may be damaged when the temperature is too high, and the close contact force tends to be weak when the temperature is too low. There is no problem when pressurization is carried out near room temperature without particular temperature control. After that, the temperature at the time of high-temperature lamination pressurization is preferably 80°C to 250°C, more preferably 90°C to 140°C.

Although the pressurization treatment can be performed in an atmosphere at the atmospheric pressure, it may be possible to obtain uniform adhesive force by performing the pressurization treatment in a vacuum. As the degree of vacuum, a degree of vacuum obtained by an ordinary oil-sealed rotary pump, namely, about 10 Torr or less is sufficient.

As a device that can be used for the pressurization and heating treatment, a roll-type film laminator in a vacuum can be used in order to perform pressing in a vacuum or, for example, "MVLP" manufactured by MEIKI CO., LTD. or the like can be used in order to perform vacuum lamination using a film laminator for evacuating the air and then applying pressure at once to the entire surface of glass by a thin rubber film.

The pressurization treatment can be performed by being divided into a pressurization process and a heating process. In this case, a pressure (preferably about 0.05 MPa to 50 MPa) is first applied to the polymer film and the metal foil at a relatively low temperature (for example, a temperature of less than 80°C, more preferably 10°C or more and 60°C or less) to secure the close contact with each other, and then, the polymer film and the metal foil are heated at a pressure (preferably 20 MPa or less and 0.05 MPa or more) or normal pressure and a relatively high temperature (for example, 80°C or more, more preferably 100°C to 250°C, still more preferably 120°C to 220°C), whereby the chemical reaction at the close contact interface can be promoted and the polymer film and the metal foil can be laminated.

The appearance inspecting device 80 inspects the appearance of a laminate 104 of the metal foil 100 and the heat-resistant polymer film 102, which have been bonded to each other by the roll laminating device 70. As the appearance inspecting device 80, for example, an optical system of an automated optical inspection (AOI) device can be adopted. The appearance inspecting device 80 judges whether or not foreign matters are mixed in the laminate 104 and whether or not there is bonding unevenness based on the image acquired by the CCD camera (the image on the heat-resistant polymer film 102 side of the laminate 104) and the preset (quantified) data. The appearance inspecting device according to the present invention is not limited to the above-described appearance inspecting device 80 as long as it can inspect the appearance of the laminate of the metal foil and the heat-resistant polymer film, and conventionally known ones can be adopted.

The apparatus for manufacturing a laminate 1000 includes a peeling device (not illustrated). The peeling device peels off the heat-resistant polymer film 102 from the laminate 104 judged to have poor appearance by the appearance inspecting device 80. As the peeling device, conventionally known ones can be adopted. Since the peeling device is included, the heat-resistant polymer film 102 can be peeled off from the laminate 104 judged to have poor appearance. As a result, the metal foil 100 can be reused immediately.

In the above-described embodiment, the case where the coating device 40 for coating a metal foil with a silane coupling agent is included has been described. However, the present invention is not limited to this example, and a device for coating the second sheet (heat-resistant polymer film) with a silane coupling agent may be included instead of the coating device 40 for coating the first sheet (metal foil) with a silane coupling agent. A device for coating the second sheet (heat-resistant polymer film) with a silane coupling agent may be included in addition to the coating device 40 for coating the first sheet (metal foil) with a silane coupling agent.

In the above-described embodiment, the case where the coating device 40 for coating a metal foil with a silane coupling agent is included has been described. However, in the present invention, the coating device 40 for coating the first sheet (metal foil) with a silane coupling agent may not be included. In this case, for example, the first sheet (metal foil) coated with a silane coupling agent in advance may be used.

The laminate of the metal foil and the heat-resistant polymer film thus obtained are wound into the laminate roll 400.

The apparatus for manufacturing a laminate roll 1000 according to the present embodiment has been described above.

Next, the method for manufacturing a laminate roll according to the second embodiment will be described. Hereinafter, the method for manufacturing a laminate in the case of using the apparatus for manufacturing a laminate roll 1000 will be described, but the present invention is not limited to this example. For example, a worker and the like may carry out the step carried out by each device.

The method for manufacturing a laminate according to the first embodiment is a method for manufacturing a laminate roll including a metal foil and a heat-resistant polymer film in this order, which includes:

a step A of supplying an aqueous medium to a surface of a metal foil coated with a silane coupling agent; and

a step B of bonding the metal foil after being supplied with the aqueous medium and a heat-resistant polymer film to each other.

It is preferable that the method for manufacturing a laminate roll further includes:

a step X-2 of cleaning a metal foil;
a step X-1 of coating a metal foil with a silane coupling agent after the step X-2;
a step X-3 of cleaning a heat-resistant polymer film;
a step X-4 of inspecting appearance of a laminate of a metal foil and a heat-resistant polymer film, which have been bonded to each other, after the step B; and
a step X-5 of peeling off a heat-resistant polymer film from a laminate judged to have poor appearance in the step X-4.

In the method for manufacturing a laminate roll, first, the metal foil 100 is moved in the direction of the metal foil cleaning device 30, and the metal foil is cleaned by the metal foil cleaning device 30 (step X-2).

Next, the metal foil 100 is moved in the direction of the coating device 40, and the metal foil is coated with a silane coupling agent by the coating device 40 (step X-1).

Meanwhile, the surface of the heat-resistant polymer film 102 is cleaned by the film cleaning device 60 by spraying the cleaning liquid 64 onto the heat-resistant polymer film 102 supplied from the film roll 300 and then blowing air on the surface using the air knife (not illustrated) (step X-3).

Next, the aqueous medium 52 is supplied to the surface of the metal foil 100 coated with a silane coupling agent by the water supply device 50 (step A).

Next, the metal foil 100 after being supplied with the aqueous medium 52 and the heat-resistant polymer film 102 are bonded to each other by the roll laminating device 70 (step B) .

Next, the appearance of the laminate 104 of the metal foil 100 and the heat-resistant polymer film 102, which have been bonded to each other, by the appearance inspecting device 80 (step X-4).

Next, the heat-resistant polymer film 102 is peeled from the laminate 104 judged to have poor appearance in the step X-4 by the peeling device (step X-5).

In the above-described embodiment, the case where the metal foil is coated with a silane coupling agent has been described. However, the present invention is not limited to this example, and the second sheet (heat-resistant polymer film) may be coated with a silane coupling agent instead of coating the first sheet (metal foil) with a silane coupling agent. The second sheet (heat-resistant polymer film) may be coated with a silane coupling agent as well as the first sheet (metal foil) is coated with a silane coupling agent.

In the above-described embodiment, the case where the metal foil is coated with a silane coupling agent has been described. However, in the present invention, the step of coating the first sheet (metal foil) with a silane coupling agent may not be included. In this case, for example, the first sheet (metal foil) coated with a silane coupling agent in advance may be used.

The method for manufacturing a laminate according to the second embodiment has been described above.

Next, the heat-resistant polymer film, the metal foil, the silane coupling agent, and the aqueous medium will be described.

The heat-resistant polymer film according to the second embodiment can have a configuration similar to that of the polymer film described in the first embodiment.

The average CTE of the polymer film at between 30°C and 300°C is preferably -5 ppm/°C to +20 ppm/°C, more preferably -3 ppm/°C to +15 ppm/°C, still more preferably -1 ppm/°C to +10 ppm/°C. When the CTE is in the above range, a small difference in coefficient of linear thermal expansion between the polymer film and a general support (metal foil) can be maintained, and the polymer film and the metal foil can be prevented from peeling off from each other when being subjected to a process of applying heat as well.

The polymer film can be fabricated to preferably have a width of at least 700 mm or more. The length of the film is preferably at least 10 m, and the upper limit of the length is not particularly limited. The polymer film is preferably supplied in a state of being wound into a roll shape.

According to the apparatus for manufacturing a laminate 1000, the bonding can be performed in a state in which at least a part of the silane coupling agent is dissolved in the aqueous medium, and it is thus possible to have uniform adhesive strength when the heat-resistant polymer film is large (having a width of at least 700 mm or more and a length of 10 m or more) as well.

The metal foil includes single element metals such as W, Mo, Pt, Fe, Ni, Au, and Cu, alloys such as Inconel, Monel, Nimonic, carbon-copper, Fe-Ni-based Invar alloy, and Super Invar alloy, and various stainless steels, and the like. Multilayer metal plates formed by adding another metal layer or a ceramic layer to these metals are also included. In this case, when the overall coefficient of linear thermal expansion (CTE) with the additional layer is low, Cu, Al and the like are also used in the main metal layer. The metals used as the addition metal layer is not limited as long as they are those that strengthen the close contact property with the polymer film, those that have properties that there is no diffusion and the chemical resistance and heat resistance are favorable, but suitable examples thereof include Cr, Ni, TiN, and Mo-containing Cu.

It is desirable that the planar portion of the metal foil is sufficiently flat. Specifically, the P-V value of **the surface roughness is 5 μm or less, more preferably 1 μm** or **less, still more preferably 0.3 μm or less.** When the surface is coarser than this, the adhesive strength between the polymer film layer and the metal foil may be insufficient.

The thickness of the metal foil is not particularly limited, but a thickness of 1 mm or less is preferable, a thickness of 0.3 mm or less is more preferable, and a thickness of 0.08 mm or less is still more preferable from the viewpoint of handleability. The lower limit of the thickness is not particularly limited, but is preferably 0.001 mm or more, more preferably 0.05 mm or more, still more preferably 0.02 mm or more.

The silane coupling agent has an action of being physically or chemically interposed between the metal foil and the polymer film and bonding the metal foil and the polymer film to each other. The silane coupling agent can have a configuration similar to that of the silane coupling agent described in the first embodiment.

As the method for applying a silane coupling agent (method for forming a silane coupling agent layer), a method in which a silane coupling agent solution is applied to the metal foil, a vapor deposition method, and the like can be used. The silane coupling agent layer may be formed on the surface of the heat-resistant polymer film. The application of the silane coupling agent can be performed using the coating device 40.

The aqueous medium may have a configuration similar to that of the aqueous medium described in the first embodiment.

The aqueous medium is used to wet the opposing surfaces at the time of bonding of the polymer film and the metal foil, namely, the bonding surfaces.

The apparatus for manufacturing a laminate roll and the method for manufacturing a laminate roll according to the second embodiment have been described above.

Next, the apparatus for manufacturing a heat-resistant polymer film laminate and the method for manufacturing a heat-resistant polymer film laminate according to the third embodiment will be described.

[Third embodiment]

The apparatus for manufacturing a heat-resistant polymer film laminate according to the third embodiment has the following configurations.

(1) An apparatus for manufacturing a heat-resistant polymer film laminate, the apparatus including:

a film transporting device for transporting a first heat-resistant polymer film;

a water supply device for supplying an aqueous medium to a surface of a first heat-resistant polymer film coated with a silane coupling agent and/or a surface of a second heat-resistant polymer film coated with a silane coupling agent; and

a laminating device for bonding the first heat-resistant polymer film and the second heat-resistant polymer film to each other after an aqueous medium has been supplied to either or both of the first heat-resistant polymer film and the second heat-resistant polymer film.

(2) The apparatus for manufacturing a heat-resistant polymer film laminate according to (1), which include a coating device for coating a first heat-resistant polymer film with a silane coupling agent.

(3) The apparatus for manufacturing a heat-resistant polymer film laminate according to (1) or (2), which includes a first heat-resistant polymer film cleaning device for cleaning a first heat-resistant polymer film before being supplied with an aqueous medium.

(4) The apparatus for manufacturing a heat-resistant polymer film laminate according to any one (1) to (3), which includes a second heat-resistant polymer film cleaning device for cleaning a second heat-resistant polymer film before being supplied with an aqueous medium.

(5) The apparatus for manufacturing a heat-resistant polymer film laminate according to any one of (1) to (4), in which the second heat-resistant polymer film has a width of 90 mm or more.

(6) The apparatus for manufacturing a heat-resistant polymer film laminate according to any one of (1) to (5), in which a pressing pressure of the laminating device is 0.2 MPa or more.

The method for manufacturing a heat-resistant polymer film laminate according to the third embodiment has the following configurations.

(7) An method for manufacturing a heat-resistant polymer film laminate, which is a method for manufacturing a heat-resistant polymer film laminate of a first heat-resistant polymer film and a second heat-resistant polymer film, the method including:

a step A of supplying an aqueous medium to a surface of a first heat-resistant polymer film coated with a silane coupling agent and/or a surface of a second heat-resistant polymer film coated with a silane coupling agent; and

a step B of bonding the first heat-resistant polymer film and the second heat-resistant polymer film to each other after an aqueous medium has been supplied to either or both of the first heat-resistant polymer film and the second heat-resistant polymer film.

(8) The method for manufacturing a heat-resistant polymer film laminate, according to (7), which includes a step X-1 of coating a first heat-resistant polymer film with a silane coupling agent before the step A.

(9) The method for manufacturing a heat-resistant polymer film laminate, according to (7) or (8), which includes a step X-2 of cleaning a first heat-resistant polymer film before the step A.

(10) The method for manufacturing a heat-resistant polymer film laminate, according to any one of (7) to (9), which includes a step X-3 of cleaning a second heat-resistant polymer film before the step A.

(11) The method for manufacturing a heat-resistant polymer film laminate according to any one of (7) to (10), which includes a step X-4 of inspecting appearance of a heat-resistant polymer film laminate of a first heat-resistant polymer film and a second heat-resistant polymer film, which have been bonded to each other, after the step B.

(11) The method for manufacturing a heat-resistant polymer film laminate according to any one of (7) to (11), in which a pressing pressure in a step B is 0.2 MPa or more.

In the third embodiment, the "first heat-resistant polymer film" corresponds to the "first sheet" in the present embodiment, the "film transporting device" corresponds to the "first sheet transporting device" in the present embodiment, the "second heat-resistant polymer film" corresponds to the "second sheet" in the present embodiment, the "apparatus for manufacturing a heat-resistant polymer film laminate" corresponds to the "apparatus for manufacturing a laminate" in the present embodiment, the "first heat-resistant polymer film cleaning device" corresponds to the "first cleaning device" in the present embodiment, and the "second heat-resistant polymer film cleaning device" corresponds to the "second cleaning device" in the present embodiment.

Next, the apparatus for manufacturing a heat-resistant polymer film laminate and the method for manufacturing a heat-resistant polymer film laminate according to the third embodiment will be specifically described.

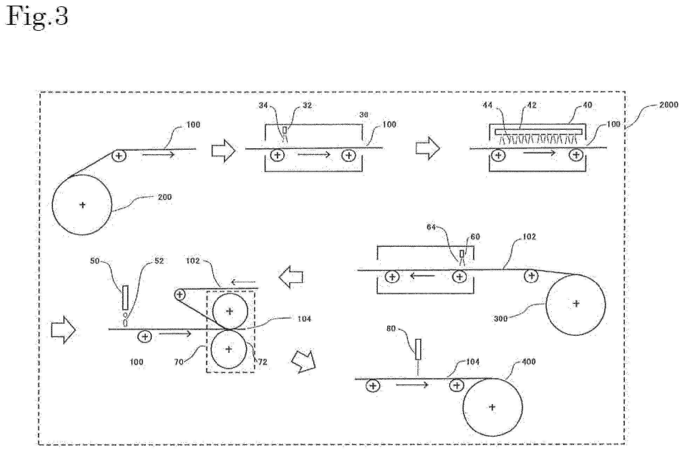

Fig. 3 is a schematic diagram for explaining the apparatus for manufacturing a heat-resistant polymer film laminate according to the third embodiment. In the third embodiment, a case where the apparatus for manufacturing a heat-resistant polymer film laminate is an apparatus for manufacturing a laminate roll will be described, but the laminate manufactured using the apparatus for manufacturing a heat-resistant polymer film laminate of the third embodiment is not limited to a laminate roll and may be a laminate obtained in the form of a sheet. The same reference numerals are given to the configurations common to the apparatus for manufacturing a laminate 10 according to the first embodiment.

As illustrated in Fig. 3, an apparatus for manufacturing a laminate roll 2000 according to the third embodiment includes a device having a function of unwinding a first heat-resistant polymer film from a first heat-resistant polymer film roll 200 and transporting the first heat-resistant polymer film, a first heat-resistant polymer film cleaning device 30, a coating device 40, a water supply device 50, a device having a function of unwinding a second heat-resistant polymer film from a second heat-resistant polymer film roll 300 and transporting the second heat-resistant polymer film, a second heat-resistant polymer film cleaning device 60, a roll laminating device 70, an appearance inspecting device 80, and a winding device for finally winding a laminate into a laminate roll 400. However, the apparatus for manufacturing a laminate in the present invention is only required to include at least a first sheet transporting device (a device for transporting a first heat-resistant polymer film), a water supply device, and a roll laminating device.

The first heat-resistant polymer film 100 is unwound from the first heat-resistant polymer film roll 200, transported, and moved between the respective devices included in the apparatus for manufacturing a laminate roll 2000. The first heat-resistant polymer film transportation is not particularly limited as long as it is possible to transport the first heat-resistant polymer film 100, but it is desirable that the first heat-resistant polymer film transportation can automate the manufacture of a laminate.

The first heat-resistant polymer film cleaning device 30 includes a cleaning liquid spray nozzle 32, an air knife (not illustrated), and the like. The first heat-resistant polymer film cleaning device 30 can spray a cleaning liquid 34 onto the first heat-resistant polymer film 100 and then dry the surface of the first heat-resistant polymer film 100 by blowing air on the surface using the air knife. The first cleaning device (first heat-resistant polymer film cleaning device) according to the present invention is not limited to the above-described first heat-resistant polymer film cleaning device 30 as long as it can preferably continuously clean the first sheet (first heat-resistant polymer film) before being supplied with an aqueous medium, and conventionally known ones can be adopted.

The coating device 40 preferably includes a silane coupling agent supply pipe 42 provided with a plurality of small holes, and the like. The coating device 40 can coat the first heat-resistant polymer film 100 with a silane coupling agent 44 from the silane coupling agent supply pipe 42. The coating device 40 according to the present invention is not limited to the above-described coating device 40 as long as it can coat the first heat-resistant polymer film 100 with the silane coupling agent 44, and conventionally known ones can be adopted. The silane coupling agent 44 may be in the form of a liquid or in the form of a gas. A gaseous silane coupling agent is preferable since the first heat-resistant polymer film 100 can be uniformly coated.

The water supply device 50 supplies an aqueous medium 52 to the surface of the first heat-resistant polymer film 100 coated with a silane coupling agent. The configuration of the water supply device 50 is not particularly limited as long as it can supply the aqueous medium 52 to the surface of the first heat-resistant polymer film 100 coated with a silane coupling agent, and conventionally known ones can be adopted. The amount of the aqueous medium 52 supplied is not particularly limited, but is preferably about 0.1 to 50 g (0.1 to 50 g/100 cm$^2$), more preferably 1 to 30 g/100 cm$^2$ per unit area (100 cm$^2$) of the first heat-resistant polymer film from the viewpoint of decreasing bubbles and foreign matters.

A second heat-resistant polymer film 102 is unwound from the second heat-resistant polymer film roll 300 and guided to the second heat-resistant polymer film cleaning device 60. The second heat-resistant polymer film cleaning device 60 can clean the surface of the second heat-resistant polymer film 102 by spraying a cleaning liquid 64 onto the second heat-resistant polymer film 102 and then blowing air on the surface using an air knife (not illustrated). The second cleaning device (second film cleaning device) according to the present invention is not limited to the above-described second heat-resistant polymer film cleaning device 60 as long as it can preferably continuously clean the second sheet (second heat-resistant polymer film) before being supplied with an aqueous medium, and conventionally known ones can be adopted.

The roll laminating device 70 includes a laminating roller 72 and the like. The roll laminating device 70 bonds the first heat-resistant polymer film 100 and the second heat-resistant polymer film 102, which have been supplied with the aqueous medium 52, to each other by performing pressing (pressurization treatment) using the laminating roller 72. The pressing pressure at the time of bonding is preferably 0.2 MPa or more. According to the apparatus for manufacturing a laminate 2000, the bonding can be performed in a state in which at least a part of the silane coupling agent 44 is dissolved in the aqueous medium 52, and thus unevenness at the time of lamination can be suppressed. The laminating device (roll laminating device) according to the present invention is not limited to the above-described roll laminating device 70 as long as it can bond the first heat-resistant polymer film and the second heat-resistant polymer film, which have been supplied with an aqueous medium, to each other, and conventionally known ones can be adopted.

The pressing pressure of the roll laminating device 70 is preferably 0.2 MPa or more. Since the bonding can be performed in a state in which at least a part of the silane coupling agent is dissolved in the aqueous medium, unevenness at the time of lamination can be suppressed. When the pressing pressure is 0.2 MPa or more, trapping of air between the bonded heat-resistant polymer films can be suppressed.

The lower limit of the pressing pressure is not particularly limited, but is preferably 0.5 MPa or more. When the pressing pressure is 0.5 MPa or more, it is possible to prevent the generation of a portion that is not in close contact and insufficient adhesion. The temperature at the time of pressurization is preferably 10°C to 60°C, more preferably 20°C to 40°C. The aqueous solution may vaporize and generate bubbles and the polymer film may be damaged when the temperature is too high, and the close contact force tends to be weak when the temperature is too low. There is no problem when pressurization is carried out near room temperature without particular temperature control. After that, the temperature at the time of high-temperature lamination pressurization is preferably 80°C to 250°C, more preferably 90°C to 200°C.

In the roll laminating device 70, it is desirable that at least either of the upper or lower roll 72 used for lamination is a roll formed of a flexible material. The roll formed of a flexible material here refers to a silicon rubber roll or the like having an elastic modulus of 300 MPa or less. When at least one of the rolls used for lamination is formed of a flexible material, a high-quality film laminate with less bubbles trapped can be fabricated.

Although the pressurization treatment can be performed in an atmosphere at the atmospheric pressure, it may be possible to obtain uniform adhesive force by performing the pressurization treatment in a vacuum. As the degree of vacuum, a degree of vacuum obtained by an ordinary oil-sealed rotary pump, namely, about 10 Torr or less is sufficient.

As an apparatus that can be used for the pressurization and heating treatment, a roll-type film laminator in a vacuum can be used in order to perform pressing in a vacuum. Alternatively, for example, "MVLP" manufactured by MEIKI CO., LTD. or the like can be used in order to perform vacuum lamination using a film laminator for evacuating the air and then applying pressure at once to the entire surface of glass by a thin rubber film.

The pressurization and heating treatment can be performed by being divided into a pressurization process and a heating process. In this case, a pressure (preferably about 0.05 MPa to 50 MPa) is first applied to the first heat-resistant polymer film and the second heat-resistant polymer film at a relatively low temperature (for example, a temperature of less than 80°C, more preferably 10°C or more and 60°C or less) to secure the close contact with each other, and then, the first heat-resistant polymer film and the second heat-resistant polymer film are heated at a pressure (preferably 0.2 MPa or more and 20 MPa or less) or normal pressure and a relatively high temperature (for example, 80°C or more, more preferably 100°C to 250°C, still more preferably 120°C to 220°C), whereby the chemical reaction at the close contact interface can be promoted and the first and second heat-resistant polymer films can be laminated.

The appearance inspecting device 80 inspects the appearance of a laminate 104 of the first heat-resistant polymer film 100 and the second heat-resistant polymer film 102, which have been bonded to each other by the roll laminating device 70. As the appearance inspecting device 80, for example, an optical system of an automated optical inspection (AOI) device can be adopted. The appearance inspecting device 80 judges whether or not foreign matters are mixed in the laminate 104 and whether or not there is bonding unevenness based on the image acquired by the CCD camera (the image on the second heat-resistant polymer film 102 side of the laminate 104) and the preset (quantified) data. The appearance inspecting device according to the present invention is not limited to the above-described appearance inspecting device 80 as long as it can inspect the appearance of the laminate of the first and second heat-resistant polymer films, and conventionally known ones can be adopted.

In the above-described embodiment, the case where the coating device 40 for coating a first heat-resistant polymer film with a silane coupling agent is included has been described. However, the present invention is not limited to this example, and a device for coating the second sheet (second heat-resistant polymer film) with a silane coupling agent may be included instead of the coating device 40 for coating the first sheet (first heat-resistant polymer film) with a silane coupling agent. A device for coating the second sheet (second heat-resistant polymer film) with a silane coupling agent may be included in addition to the coating device 40 for coating the first sheet (first heat-resistant polymer film) with a silane coupling agent.

In the above-described embodiment, the case where the coating device 40 for coating a first heat-resistant polymer film with a silane coupling agent is included has been described. However, in the present invention, the coating device 40 for coating the first sheet (first heat-resistant polymer film) with a silane coupling agent may not be included. In this case, for example, the first sheet (first heat-resistant polymer film) coated with a silane coupling agent in advance may be used.

The laminate of the first heat-resistant polymer film and the second heat-resistant polymer film thus obtained are wound into the laminate roll 400.

The apparatus for manufacturing a laminate roll 2000 according to the present embodiment has been described above.

Next, the method for manufacturing a laminate according to the third embodiment will be described. Hereinafter, the method for manufacturing a laminate in the case of using the apparatus for manufacturing a laminate roll 2000 will be described, but the present invention is not limited to this example. For example, a worker and the like may carry out the step carried out by each device.

The method for manufacturing a laminate according to the third embodiment is a method for manufacturing a laminate including a first heat-resistant polymer film and a second heat-resistant polymer film in this order, the method including:

a step A of supplying an aqueous medium to a surface of a first heat-resistant polymer film coated with a silane coupling agent and/or a surface of a second heat-resistant polymer film coated with a silane coupling agent; and a step B of bonding the first heat-resistant polymer film and the second heat-resistant polymer film, which have been supplied with the aqueous medium, to each other.

It is preferable that the method for manufacturing a laminate further includes:

a step X-2 of cleaning a first heat-resistant polymer film;
a step X-1 of coating a first heat-resistant polymer film with a silane coupling agent after the step X-2;
a step X-3 of cleaning a second heat-resistant polymer film; and
a step X-4 of inspecting appearance of a laminate of a first heat-resistant polymer film and a second heat-resistant polymer film, which have been bonded to each other, after the step B.

In the method for manufacturing a laminate, first, the first heat-resistant polymer film 100 is moved in the direction of the first heat-resistant polymer film cleaning device 30 and the first heat-resistant polymer film is cleaned by the first heat-resistant polymer film cleaning device 30 (step X-2).

Next, the first heat-resistant polymer film 100 is moved in the direction of the coating device 40, and the first heat-resistant polymer film is coated with a silane coupling agent by the coating device 40 (step X-1).

Meanwhile, the surface of a second heat-resistant polymer film 102 is cleaned by the second heat-resistant polymer film cleaning device 60 by spraying the cleaning liquid 64 onto the second heat-resistant polymer film 102 supplied from the second heat-resistant polymer film roll 300 and then blowing air on the surface using the air knife (not illustrated) (step X-3).

Next, the aqueous medium 52 is supplied to the surface of the first heat-resistant polymer film 100 coated with a silane coupling agent by the water supply device 50 (step A).

Next, the first heat-resistant polymer film 100 and the second heat-resistant polymer film 102, which have been supplied with the aqueous medium 52, are bonded to each other by the roll laminating device 70 (step B).

The bonding (step B) is preferably carried out immediately after the supply of the aqueous medium 52 (step A). It is more preferable to complete the bonding at least before the aqueous medium 52 dries (evaporates).

Next, the appearance of a laminate 104 of the first heat-resistant polymer film 100 and the second heat-resistant polymer film 102, which have been bonded to each other, is inspected by the appearance inspecting device 80 (step X-4).

The manufacturing method is preferably a method for manufacturing a laminated roll.

In the above-described embodiment, the case where the first heat-resistant polymer film is coated with a silane coupling agent has been described. However, the present invention is not limited to this example, and the second sheet (second heat-resistant polymer film) may be coated with a silane coupling agent instead of coating the first sheet (first heat-resistant polymer film) with a silane coupling agent. The second sheet (second heat-resistant polymer film) may be coated with a silane coupling agent as well as the first sheet (first heat-resistant polymer film) is coated with a silane coupling agent.

In the above-described embodiment, the case where the first heat-resistant polymer film is coated with a silane coupling agent has been described. However, in the present invention, the step of coating the first sheet (first heat-resistant polymer film) with a silane coupling agent may not be included. In this case, for example, the first sheet (first heat-resistant polymer film) coated with a silane coupling agent in advance may be used.

The method for manufacturing a laminate according to the third embodiment has been described above.

Next, the first heat-resistant polymer film, the second heat-resistant polymer film, the silane coupling agent, and the aqueous medium will be described.

The first heat-resistant polymer film and second heat-resistant polymer film according to the third embodiment can have configurations similar to that of the heat-resistant polymer film described in the first embodiment.

The first heat-resistant polymer film and the second heat-resistant polymer film may be the same kind of resin or different kinds of resins. In the case of the same kind of resin, the first heat-resistant polymer film and the second heat-resistant polymer film may have the same composition or different compositions. The melting points and the glass transition temperatures thereof may also be the same as or different from each other. It is preferable that the first heat-resistant polymer film and the second heat-resistant polymer film are resins which are the same kind and have the same composition as each other. Among others, it is preferable that the first heat-resistant polymer film and the second heat-resistant polymer film are both aromatic polyimide films having the same benzoxazole structure.

The average CTE of the polymer film at between 30°C and 300°C is preferably -5 ppm/°C to +20 ppm/°C, more preferably -3 ppm/°C to +15 ppm/°C, still more preferably -1 ppm/°C to +10 ppm/°C as described in the first embodiment. When the CTE is within the above range, it is possible to use the laminate, the metal parts and the like together when a process of applying heat is performed as well.

The polymer film can be fabricated to preferably have a width of at least 90 mm or more. The length of the film is preferably at least 10 m, and the upper limit of the length is not particularly limited. The polymer film is preferably supplied in a state of being wound into a roll shape.

According to the apparatus for manufacturing a laminate 10, the bonding can be performed in a state in which at least a part of the silane coupling agent is dissolved in the aqueous medium, and it is thus possible to have uniform adhesive strength when the heat-resistant polymer film is large (having a width of at least 90 mm or more and a length of 10 m or more) as well.

The silane coupling agent has an action of being physically or chemically interposed between the first heat-resistant polymer film and the second heat-resistant polymer film and bonding the heat-resistant polymer films to each other. The silane coupling agent can have a configuration similar to that of the silane coupling agent described in the first embodiment.

As the method for applying a silane coupling agent (method for forming a silane coupling agent layer), a method in which a silane coupling agent solution is applied to the first heat-resistant polymer film and the second heat-resistant polymer film, a vapor deposition method, and the like can be used. The application of the silane coupling agent can be performed using the coating device 40.

The aqueous medium may have a configuration similar to that of the aqueous medium described in the first embodiment.

The aqueous medium is used to wet the opposing surfaces at the time of bonding of the first heat-resistant polymer film and the second heat-resistant polymer film, namely, the bonding surfaces.

The apparatus for manufacturing a heat-resistant polymer film laminate and the method for manufacturing a heat-resistant polymer film laminate according to the third embodiment have been described.

Next, the laminate according to the present embodiment will be described.

The laminate according to the present embodiment has the following configurations.

(1) A laminate including an inorganic substrate, a silane coupling agent layer containing an amino group, and a heat-resistant polymer film in this order, in which
a nitrogen element component ratio on a peeled surface on an inorganic substrate side after the heat-resistant polymer film has been peeled off from the inorganic substrate at 90° is 2.5 atomic% or more and 3.5 atomic% or less.
(2) The laminate according to (1), in which an adhesive strength by a 90-degree peeling method when the heat-resistant polymer film is peeled off from the laminate is 0.05 N/cm or more and 0.25 N/cm or less.
(3) The laminate according to (1) or (2), in which the heat-resistant polymer film is a polyimide film.
(4) The laminate according to any one of (1) to (3), in which a blister defect density is 5 spots or less per 1 square meter.
(5) The laminate according to any one of (1) to (4), in which the heat-resistant polymer film is rectangular, has an area of 0.65 square meter or more, and has a rectangular side of at least 700 mm or more.

The laminate according to the present embodiment can be manufactured using the apparatus for manufacturing a laminate according to the present embodiment (for example, the apparatus for manufacturing a laminate according to the first embodiment, the apparatus for manufacturing a laminate roll according to the second embodiment, and the apparatus for manufacturing a heat-resistant polymer film laminate according to the third embodiment). The laminate according to the present embodiment can be manufactured by the method for manufacturing a laminate according to the present embodiment (for example, the method for manufacturing a laminate according to the first embodiment, the method for manufacturing a laminate roll according to the second embodiment, and the method for manufacturing a heat-resistant polymer film laminate according to the third embodiment).

However, the laminate according to the present embodiment is not required to be manufactured using the apparatus for manufacturing a laminate as long as it has the configuration of (1).

The heat-resistant polymer film according to the present embodiment can have a configuration similar to that of the polymer film described in the first embodiment.

The inorganic substrate according to the present embodiment can have a configuration similar to that of the inorganic substrate described in the first embodiment.

The silane coupling agent according to the present embodiment has an action of being physically or chemically interposed between the inorganic substrate and the metal-containing layer and bonding the inorganic substrate and the polymer film to each other. The silane coupling agent contains a coupling agent having at least an amino group. An amino group is generally highly reactive, and the reactivity of an amino group with an imide bond and an amide bond is high when the film has an imide bond and an amide bond. In the present embodiment, since the silane coupling agent contains at least a coupling agent having an amino group, it is easy to increase the bond strength between the inorganic substrate and the polymer film.

The silane coupling agent according to the present embodiment can have a configuration similar to that of the coupling agent having an amino group among the silane coupling agents described in the first embodiment.

The nitrogen element component ratio on the peeled surface on the inorganic substrate side after the heat-resistant polymer film has been peeled off from the inorganic substrate at 90° is 2.5 atomic% or more and 3.5 atomic% or less.

As described in the prior art, in a laminate of a heat-resistant polymer film and an inorganic substrate mainly such as a glass plate for manufacturing a flexible electronic device, particularly when the laminate has a large area, it is difficult to homogenously apply a silane coupling agent, and as a result, it is difficult to uniformly and properly control the adhesive strength between the heat-resistant polymer film and the inorganic substrate.

However, according to the present embodiment, this adhesive strength can be controlled in a range of 0.05 N/cm or more and 0.25 N/cm or less, further blister defects between the heat-resistant polymer film and the inorganic substrate are less likely to be generated, a large-area laminate, which is a rectangle having an area of 0.8 square meter and has a side of at least 1 m or more can be realized, and further a method for manufacturing a flexible electronic device having a large area can be provided by using this laminate.

By adopting the apparatus for manufacturing a laminate and/or the method for manufacturing a laminate according to the present embodiment, in the laminate according to the present embodiment, the excess silane coupling agent between the inorganic substrate and the polymer film can be removed, and the amount of the silane coupling agent is controlled to the minimum necessary amount arranged on the surface of at least either of the substrate or the film by the affinity.

It is presumed that the adhesive force between the substrate and the polymer film changes over time or after the substrate and the polymer film have undergone a high-temperature process because the reaction of the silane coupling agent, which is excessively present and unreacted, proceeds. However, such an excess unreacted material can be eliminated from the bonding interface between the substrate and the film by adopting the apparatus for manufacturing a laminate and/or the method for manufacturing a laminate according to the present embodiment.

By adopting the apparatus for manufacturing a laminate and/or the method for manufacturing a laminate according to the present embodiment, in the laminate according to the present embodiment, it is possible to obtain a laminate in which the N element on the surface of the inorganic substrate, from which the film has been peeled off, observed by ESCA is 2.5 atomic% or more and 3.5 atomic% or less. This N element reflects the presence of an amino group-containing silane coupling agent.

Furthermore, in this bonding method, the excess silane coupling agent is eliminated, thus foreign matters due to the condensation of the silane coupling agent are less likely to be generated, and at the same time, dust and the like coexisting on the bonding surface are pushed out, thus foreign matters having a particle size at the bonding interface drastically decrease, and as a result, the number of blister defects (also called bubbles, floats, and the like), in which these foreign matters are the nuclei, decreases.

According to the above configuration, namely, a configuration in which the nitrogen element component ratio on the peeled surface on the inorganic substrate side after the heat-resistant polymer film has been peeled off from the inorganic substrate at 90° is 2.5 atomic% or more and 3.5 atomic% or less, the silane coupling agent layer is thick enough to have sufficient adhesive strength, there is no excess silane coupling agent, thus the adhesive strength is not too strong, and the adhesive strength can be in a range of 0.05 N/cm or more and 0.25 N/cm or less. This is clear from Examples as well. In this regard, the present inventors presume that since a large number of OH groups are present on the surface of the inorganic substrate at the initial stage of depositing the silane coupling agent on the inorganic substrate, as a result of binding between the OH groups and the silane coupling agent layer by a hydrogen bond, a chemical reaction and the like, a firm silane coupling agent layer is obtained. However, when the deposition time of silane coupling agent is increased, the silane coupling agent layer, which does not necessarily have a firm bond, easily enters the heat-resistant polymer film, and the adhesive strength changes depending on the entering method and the binding method at the entered location.

In the configuration, it is preferable that the adhesive strength between the heat-resistant polymer film and the inorganic substrate by a 90-degree peeling method is 0.05 N/cm or more and 0.25 N/cm or less.

When the 90-degree adhesive strength is 0.05 N/cm or more, it is possible to suitably prevent the heat-resistant polymer film from peeling off from the inorganic substrate before and during device formation.

When the 90-degree adhesive strength is 0.25 N/cm or less, the device can be peeled off without being destroyed at the time of mechanical peeling.

In the configuration, it is preferable that the number of bubbles between the heat-resistant polymer film and the inorganic substrate is 1 or less per 500 mm × 500 mm.

When the number of bubbles is 1 or less per 500 mm × 500 mm, it is possible to remarkably decrease the possibility that the device is destroyed by the growth of bubbles when the device is fabricated on the heat-resistant polymer film.

The laminate obtained using the apparatus for manufacturing a laminate according to the present embodiment and/or the laminate obtained by the method for manufacturing a laminate according to the present embodiment preferably has the following properties.

In the laminate, the initial adhesive strength between the heat-resistant polymer film and the inorganic substrate by a 90-degree peeling method is preferably 0.05 N/cm or more and 0.25 N/cm or less. The blister defect density is preferably 5 spots or less per 1 square meter.

In the laminate, the initial adhesive strength between the heat-resistant polymer film and the inorganic substrate by a 90-degree peeling method is preferably 0.05 N/cm or more, more preferably 0.09 N/cm or more, still more preferably 0.1 N/cm or more. The 90-degree initial adhesive strength is preferably 0.25 N/cm or less, more preferably 0.2 N/cm or less. When the 90-degree initial adhesive strength is 0.05 N/cm or more, it is possible to prevent the heat-resistant polymer film from peeling off from the inorganic substrate before and during device formation. When the 90-degree initial adhesive strength is 0.25 N/cm or less, the inorganic substrate and the heat-resistant polymer film are easily peeled off from each other after device formation. In other words, when the 90-degree initial adhesive strength is 0.25 N/cm or less, the inorganic substrate and the heat-resistant polymer film are easily peeled off from each other even if the adhesive strength therebetween slightly increases during device formation.

In the present specification, the 90-degree initial adhesive strength refers to the 90-degree adhesive strength between the inorganic substrate and the heat-resistant polymer film after the laminate is subjected to a heat treatment at 200°C for 1 hour in the atmospheric air atmosphere.

In the laminate, the adhesive strength after heat treatment between the heat-resistant polymer film and the inorganic substrate by a 90-degree peeling method is preferably 0.05 N/cm or more, more preferably 0.09 N/cm or more, still more preferably 0.1 N/cm or more. The adhesive strength after heat treatment is preferably 0.25 N/cm or less, more preferably 0.2 N/cm or less.

In the present specification, the initial adhesive strength after heat treatment refers to the 90-degree adhesive strength between the inorganic substrate and the heat-resistant polymer film after the laminate is subjected to a heat treatment at 200°C for 1 hour in the atmospheric air atmosphere and then to a heat treatment at 450°C for 1 hour.

In the present specification, the "adhesive strength" means both "initial adhesive strength" and "adhesive strength after heat treatment". In other words, the "adhesive strength of 0.05 N/cm or more and 0.25 N/cm or less" means that the "initial adhesive strength is 0.05 N/cm or more and 0.25 N/cm or less" and the "adhesive strength after heat treatment is 0.05 N/cm or more and 0.25 N/cm or less".

The measurement conditions of the initial adhesive strength and the adhesive strength after heat treatment are as follows.

The heat-resistant polymer film is peeled off from the inorganic substrate at an angle of 90 degrees.

The measurement is performed 5 times and the average value thereof is taken as the measured value.

Measured temperature: Room temperature (25°C)
Peeling speed: 100 mm/min
Atmosphere: Atmospheric air
Width of measured sample: 2.5 cm

More specifically, the method described in Examples is adopted.

EXAMPLES

Hereinafter, the present invention will be described in detail with reference to Examples, but the present invention is not limited to the following Examples as long as the gist of the present invention is not exceeded.

Unless otherwise stated, the respective measured values in Examples and Comparative Examples were measured by the following methods.

<Thickness of polymer film>

The thickness of the polymer film was measured using a micrometer (Millitron 1245D manufactured by Feinpruf GmbH).

<Tensile elasticity, tensile breaking strength, and tensile breaking elongation of polymer film>

The polymer film was cut into a strip shape of 100 mm × 10 mm respectively in the machine direction (MD direction) and the transverse direction (TD direction), thereby obtaining a test piece. The test piece was cut from the center portion in the transverse direction. The tensile elasticity, tensile breaking strength, and tensile breaking elongation in each of the MD direction and the TD direction were measured at a temperature of 25°C, a tensile speed of 50 mm/min, and a distance between chucks of 40 mm using a tensile tester (Autograph (R), Model name: AG-5000A manufactured by Shimadzu Corporation).

<Coefficient of linear thermal expansion (CTE)>

The expansion/contraction rate of the polymer film in the machine direction (MD direction) and the transverse direction (TD direction) was measured under the following conditions, the expansion/contraction rate/temperature was measured at an interval of 15°C such as 30°C to 45°C and 45°C to 60°C, this measurement was performed up to 300°C, and the average value of all the measured values was calculated as CTE.

Instrument name: TMA4000S manufactured by MAC Science Corporation
Length of sample: 20 mm
Width of sample: 2 mm
Start temperature in rising temperature: 25°C
End temperature in rising temperature: 400°C
Rising rate of temperature: 5°C/min
Atmosphere: Argon

<Measurement of adhesive strength>

The adhesive strength of the polymer film from the laminate obtained in the laminate fabrication by the 90-degree peeling method was determined by the following method.
The film is peeled off from the inorganic substrate at an angle of 90 degrees.

Measuring instrument: Autograph AG-IS manufactured by Shimadzu Corporation
Measured temperature: Room temperature (25°C)
Peeling speed: 100 mm/min
Atmosphere: Atmospheric air
Width of measured sample: 2.5 cm

The measurement was performed on a total of 5 points of the center portion and four corners of the laminate, and the average value thereof was determined.
The measurement was performed immediately after the laminate was obtained (after heat treatment at 200°C for 1 hour) and after the laminate was subjected to a heat treatment at 450°C for 1 hour (after a heat treatment at 200°C for 1 hour and further a heat treatment at 450°C for 1 hour), and the former was taken as the initial adhesive strength and the latter was taken as the adhesive strength after heat treatment.

<Counting of blister defects>

In the present Example, those having a long diameter **of 300 $\mu$m or more were counted as blisters.** Blisters are also called float defects or bubble defects, are spots where the film floats like a bubble but is not bonded to the substrate, and are often generated as the film is lifted like a tent by sandwiching a relatively hard foreign matter.
In the present Example, the laminate was magnified and observed by focusing on the bonding surface between the inorganic substrate and the polymer film, and the number of **blisters having a long diameter of 300 $\mu$m or more was** counted for at least 4 sheets of laminates having a G2 (370 mm × 470 mm) size, 2 sheets of laminates having a G4.5 (730 mm × 920 mm) size, and 1 sheet of laminate having a G5 (1100 mm × 1250 mm) size, and converted to the number per 1 square meter.

<Nitrogen element component ratio>

The peeled surface obtained by peeling off the polymer film from the laminate at 90° was analyzed in a range of 50 mm × 50 mm by ESCA, and the proportion of nitrogen element present on the peeled surface of the inorganic substrate was evaluated. K-Alpha[+] (manufactured by Thermo Fisher Scientific) was used as the instrument. The measurement conditions are as follows. At the time of analysis, the background was removed by the shirley method. The surface composition ratio was the average value of the measurement results at three or more locations.

Measurement conditions
Excited X-**rays: Monochrome Al K$\alpha$ rays**
X-ray output: 12 kV, 6 mA
Photoelectron escape angle: 90°
**Spot size: 400 $\mu$m$\varphi$**

Path energy: 50 eV
Step: 0.1 eV

[Preparation of polyamic acid solution A]

The interior of a reaction vessel equipped with a nitrogen inlet tube, a thermometer, and a stirring rod was purged with nitrogen, and then 223 parts by mass of 5-amino-2-(p-aminophenyl)benzoxazole (DAMBO) and 4416 parts by mass of N,N-dimethylacetamide were added into the reaction vessel and completely dissolved. Next, SNOWTEX (DMAC-ST30, manufactured by Nissan Chemical Corporation) in **which colloidal silica (average particle size: 0.08 μm) was** dispersed in dimethylacetamide was added to the solution together with 217 parts by mass of pyromellitic dianhydride (PMDA) so that colloidal silica was 0.7% by mass with respect to the total amount of polymer solids in the polyamic acid solution A, and the mixture was stirred at a reaction temperature of 25°C for 24 hours, thereby obtaining a brown and viscous polyamic acid solution A.

[Fabrication Example 1 of polyimide film]

The polyamic acid solution A was applied (coating width: 1240 mm) to a mirror-finished endless continuous belt made of stainless steel using a die coater, and dried at 90°C to 115°C for 10 minutes. The polyamic acid film which was self-supporting after drying was peeled off from the support and both ends thereof were cut, thereby obtaining a green film.

The obtained green film was transported by a pin tenter so that the final pin sheet interval was 1140 mm, and subjected to a heat treatment at 170°C for 2 minutes as the first stage, at 230°C for 2 minutes as the second stage, and at 465°C for 6 minutes as the third stage to allow the imidization reaction to proceed. Thereafter, the film was cooled to room temperature for 2 minutes, the portions exhibiting poor flatness of both ends of the film were cut off using a slitter, and the film was then wound into a roll shape, thereby obtaining a polyimide film 1 presented in Table 1.

[Fabrication Example 2 of polyimide film]

A polyimide film 2 presented in Table 1 was obtained by performing the operation in the same manner except that the gap of the die coater was changed so that the finished **polyimide film thickness was 38 μm.**

[Polyimide film 3]

**A 25 μm**-thick polyimide film Upilex25S (registered trademark) manufactured by UBE INDUSTRIES, LTD. was used as a polyimide film 3.

<Fabrication of laminate>

(Example 1)

First, the polyimide film 1 obtained in Production Example 2 was cut to have a width of 370 mm × 500 mm. Next, UV/O$_3$ irradiation was performed for 3 minutes using a UV/O$_3$ irradiator (SKR1102N-03 manufactured by LANTECHNICAL SERVICE CO., LTD.) as a film surface treatment. At this time, the distance between the UV/O$_3$ lamp and the film was set to 30 mm.

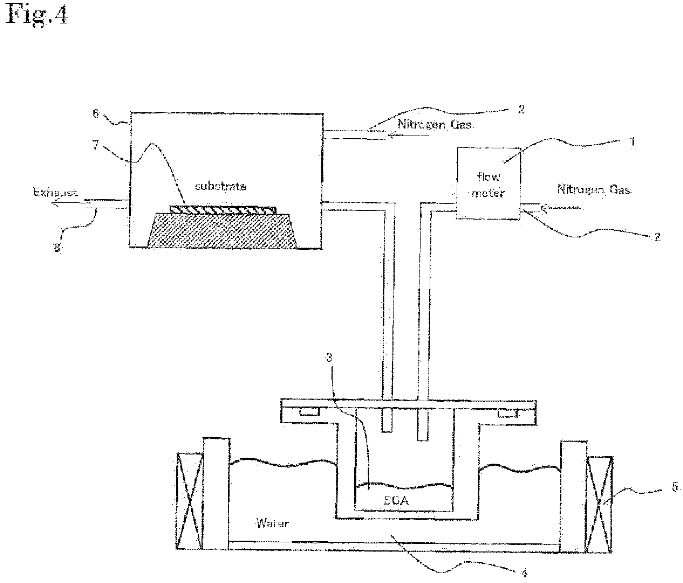

A G2 size (370 mm × 470 mm, 0.7 mm thick glass substrate: OA10G manufactured by Nippon Electric Glass Co., Ltd.) was coated with an amino group-containing silane coupling agent via the gas phase using the device of which the schematic diagram was illustrated in FIG. 4.

The glass substrate used was washed with pure water, dried, and then irradiated using a UV/O$_3$ irradiator (SKR1102N-03 manufactured by LANTECHNICAL SERVICE CO., LTD.) for 1 minute for dry cleaning.

The glass substrate was placed in the chamber of the device, and 130 g of 3-aminopropyltrimethoxysilane (KBM-903 manufactured by Shin-Etsu Chemical Co., Ltd.) was put into a chemical tank having a capacity of 1 L, the outer water bath of the chemical tank was warmed to 42°C, and the generated silane coupling agent vapor was sent to the chamber together with clean dry air at a gas flow rate of 22 L/min, and the glass substrate was exposed to this silane coupling agent vapor. At this time, the substrate temperature was set to 21°C, the clean dry air temperature was set to 23°C, and the humidity was set to 1.2% RH. Since the exhaust is connected to the exhaust port having a negative pressure, it is confirmed that the chamber has a negative pressure of about 10 Pa by the differential pressure gauge.

The glass substrate coated with an amino group-containing silane coupling agent in this manner was set in a roll laminator equipped with a silicon rubber roller. First, 100 ml of pure water as an aqueous medium was dropped onto the silane coupling agent-coated surface using a dropper so as to spread over the entire substrate, thereby wetting the substrate.

Next, the treated surface of the polyimide film was stacked on the substrate so as to face the silane coupling agent-coated surface of the glass substrate, namely, the surface wetted with pure water, and the stacked body was pressurized while extruding pure water between the polyimide film and the glass substrate using a rotating roll sequentially from one side of the glass substrate to laminate the glass substrate and the polyimide film, thereby obtaining a temporary laminate. The laminator used was a laminator having an effective roll width of 1350 mm (manufactured by MCK CO., LTD.), and the bonding conditions were: air source pressure: 0.5 MPa, laminating speed: 50 mm/sec, roll temperature: 22°C, environmental temperature: 22°C, and humidity: 55% RH.

The obtained temporary laminate was subjected to a heat treatment at 200°C for 10 minutes in a clean oven to obtain the laminate according to the present invention. Similar operation was performed on four glass substrates.

The evaluation results of the obtained laminates are presented in Table 2.

<Examples 2 to 20 and Comparative Examples 1 to 4>

The laminates were fabricated in the same manner under the conditions presented in Tables 2 to 5, and the properties of the laminates were evaluated. The results are presented in Tables 2 to 5. The abbreviations in the tables mean the following.

Film 1: Polyimide film obtained in Fabrication Example 1 of polyimide film
Film 2: Polyimide film obtained in Fabrication Example 2 of polyimide film
Film 1: Polyimide film Upilex25S (registered trademark) manufactured by UBE INDUSTRIES, LTD.
Glass: OA10G manufactured by Nippon Electric Glass Co., Ltd.
Inorganic substrate size (glass size)
G2 size (370 mm × 470 mm)
G4.5 size (730 mm × 920 mm)
G5 size (1100 mm × 1250 mm)
Aqueous medium
Pure water: Ultrapure water
Pure water+MeOH: Pure water 99/Methanol 1 (mass ratio)
Pure water+EtOH: Pure water 99/Ethanol 1 (mass ratio)

[Table 1]

| Film No. | | | 1 | 2 | 3 |
|---|---|---|---|---|---|
| | | | Fabrication Example 1 | Fabrication Example 2 | Ube Industries Upilex 25S |
| Thickness | | μm | 12.5 | 38.0 | 25.0 |
| Film width | | mm | 1160 | 1160 | 500 |
| Tensile breaking strength | MD | MPa | 446.0 | 428.0 | 515.0 |
| | TD | | 438.0 | 435.0 | 520.0 |
| Tensile elasticity | MD | GPa | 7.3 | 7.7 | 9.0 |
| | TD | | 7.2 | 7.2 | 9.1 |
| Elongation | MD | % | 32.9 | 32.8 | 38.5 |
| | TD | | 35.3 | 34.7 | 41.0 |
| Coefficient of linear expansion (CTE) | MD | -ppm/°C | 2.3 | 2.1 | 15.4 |
| | TD | | 2.7 | 2.6 | 16.8 |

[Table 2]

| | Example 1 | Example 2 | Example 3 | Example 4 | Example 5 | Example 6 |
|---|---|---|---|---|---|---|
| Film | Film 1 | Film 1 | Film 1 | Film 2 | Film 2 | Film 2 |
| Inorganic substrate | Glass | Glass | Glass | Glass | Glass | Glass |
| Inorganic substrate size | G2 | G2 | G2 | G2 | G2 | G2 |
| Film surface treatment | UV/O$_3$ | UV/O$_3$ | Atmospheric-pressure plasma | UV/O$_3$ | Atmospheric-pressure plasma | UV/O$_3$ |
| SCA coating | Glass side | Glass side | Glass side | Glass side | Glass side | Glass side |
| SCA coating time (min) | 3.0 | 7.0 | 2.0 | 2.0 | 3.0 | 3.0 |
| Inert liquid | Pure water | Pure water | Pure water | Pure water | Pure water | Pure water |
| Initial adhesive strength (N/cm) | 0.09 | 0.10 | 0.11 | 0.11 | 0.10 | 0.11 |
| Adhesive strength after heat treatment (N/cm) | 0.10 | 0.10 | 0.12 | 0.12 | 0.12 | 0.12 |
| Blister density (spots/ square meter) | 2.88 | 4.32 | 1. 44 | 2.88 | 2.88 | 2.88 |
| Nitrogen element ratio on peeled surface of inorganic substrate (element%) | 3.3 | 3.3 | 2.8 | 2.7 | 3.2 | 3.1 |

[Table 3]

| | Example 7 | Example 8 | Example 9 | Example 10 | Example 11 | Example 12 |
|---|---|---|---|---|---|---|
| Film | Film 1 | Film 1 | Film 1 | Film 2 | Film 2 | Film 3 |
| Inorganic substrate | Glass | Glass | Glass | Glass | Glass | Glass |
| Inorganic substrate size | G2 | G2 | G2 | G2 | G2 | G2 |
| Film surface treatment | UV/O$_3$ | UV/O$_3$ | Atmospheric-pressure plasma | UV/O$_3$ | Atmospheric-pressure plasma | UV/O$_3$ |
| SCA coating | Glass side | Glass side | Glass side | Glass side | Glass side | Glass side |
| SCA coating time (min) | 5.0 | 10.0 | 5.0 | 5.0 | 5.0 | 10.0 |
| Inert liquid | Pure water | Pure water | Pure water | Pure water | Pure water | Pure water |
| Initial adhesive strength (N/cm) | 0.15 | 0.08 | 0.11 | 0.09 | 0.14 | 0.10 |
| Adhesive strength after heat treatment (N/cm) | 0.17 | 0.11 | 0.18 | 0.14 | 0.16 | 0.12 |
| Blister density (spots/ square meter) | 2.88 | 4.32 | 1. 44 | 2.88 | 2.88 | 2.88 |

(continued)

|  | Example 7 | Example 8 | Example 9 | Example 10 | Example 11 | Example 12 |
|---|---|---|---|---|---|---|
| Nitrogen element ratio on peeled surface of inorganic substrate (element%) | 3.48 | 3.10 | 3.17 | 2.93 | 2.92 | 3.14 |

[Table 4]

|  | Example 13 | Example 14 | Comparative Example 1 | Comparative Example 2 | Comparative Example 3 | Comparative Example 4 |
|---|---|---|---|---|---|---|
| Film | Film 1 | Film 1 | Film 1 | Film 1 | Film 2 | Film 3 |
| Inorganic substrate | Glass | Glass | Glass | Glass | Glass | Glass |
| Inorganic substrate size | G2 | G2 | G2 | G2 | G2 | G2 |
| Film surface treatment | UV/O$_3$ | UV/O$_3$ | Atmospheric -pressure plasma | UV/O$_3$ | Atmospheric -pressure plasma | UV/O$_3$ |
| SCA coating | Film side | Film side | Glass side | Glass side | Glass side | Glass side |
| SCA coating time (min) | 3.0 | 7.0 | 3.0 | 0.5 | 3.0 | 30.0 |
| Inert liquid | Pure water | Pure water | Nil | Nil | Nil | Nil |
| Initial adhesive strength (N/cm) | 0.15 | 0.13 | 0.28 | 0.02 | 0.38 | 0.33 |
| Adhesive strength after heat treatment (N/cm) | 0.17 | 0.13 | 0.52 | 0.03 | 0.62 | 0.68 |
| Blister density (spots/ square meter) | 2.88 | 4.32 | 21.6 | 30.24 | 18.72 | 41.76 |
| Nitrogen element ratio on peeled surface of inorganic substrate (element%) | 3.33 | 2.98 | 3.80 | 0.04 | 13.78 | 24.70 |

[Table 5]

|  | Example 15 | Example 16 | Example 17 | Example 18 | Example 19 | Example 20 |
|---|---|---|---|---|---|---|
| Film | Film 2 | Film 2 | Film 1 | Film 2 | Film 1 | Film 2 |
| Inorganic substrate | Glass | Glass | Glass | Glass | Glass | Glass |
| Inorganic substrate size | G4.5 | G4.5 | G5 | G5 | G5 | G5 |
| Film surface treatment | UV/O$_3$ | UV/O$_3$ | UV/O$_3$ | UV/O$_3$ | UV/O$_3$ | UV/O$_3$ |
| SCA coating | Glass side | Film | Glass side | Glass side | Film | Film |
| SCA coating time (min) | 5.0 | 5.0 | 5.0 | 5.0 | 5.0 | 5.0 |

(continued)

|  | Example 15 | Example 16 | Example 17 | Example 18 | Example 19 | Example 20 |
|---|---|---|---|---|---|---|
| Inert liquid | Pure water | Water + EtOH | Pure water | Pure water | Pure water + EtOH | Pure water + EtOH |
| Initial adhesive strength (N/cm) | 0.09 | 0.11 | 0.08 | 0.13 | 0.16 | 0.13 |
| Adhesive strength after heat treatment (N/cm) | 0.11 | 0.15 | 0.12 | 0.14 | 0.13 | 0.10 |
| Blister density (spots/square meter) | 3.73 | 2.99 | 3.64 | 1. 45 | 2.91 | 2.18 |
| Nitrogen element ratio on peeled surface of inorganic substrate (element%) | 3.38 | 3.00 | 3.04 | 3.31 | 3.22 | 3.06 |

<Application Example>

The following steps were performed using the laminate obtained in Example 15, whereby a tungsten film (thickness: 75 nm) was formed on the polyimide film by a vacuum vapor-deposition method and further a silicon oxide film (thickness: 150 nm) as an insulating film was laminated and formed thereon without touching the atmospheric air. Next, a silicon oxide nitride film (thickness: 100 nm) to be the ground insulating film was formed by the plasma CVD method, and further an amorphous silicon film (thickness: 54 nm) was laminated and formed without touching the atmospheric air.

Next, the hydrogen element of the amorphous silicon film was removed to promote crystallization, and a heat treatment at 500°C was performed for 40 minutes to form a polysilicon film.

A TFT device was fabricated using the obtained polysilicon film. First, patterning of the polysilicon thin film was performed to form a silicon region having a predetermined shape, as appropriate, a gate insulating film was formed, a gate electrode was formed, a source region or a drain region was formed by doping the active region, the interlayer insulating film was formed, the source electrode and drain electrode were formed, and the activation treatment was performed, thereby fabricating a P-channel TFT array using polysilicon.

The polymer film portion was burned off by a UV-YAG laser along about 0.5 mm inner side of the TFT array periphery, and the polymer film was peeled off from the end of the cut using a thin razor-shaped blade so as to scoop up, thereby obtaining a flexible A3 size TFT array. The peel angle at this time is 3 degrees. The peeling was possible by extremely weak force, and it was possible to peel off the TFT array without damaging the TFT. The obtained flexible TFT array did not show any deterioration in performance **even when wound around a 3 mm$\varphi$ round bar,** and maintained favorable properties.

DESCRIPTION OF REFERENCE SIGNS

10 Apparatus for manufacturing laminate
20 Inorganic substrate transporting device (roller conveyor)
30 First cleaning device (inorganic substrate cleaning device, metal foil cleaning device, first heat-resistant polymer film cleaning device)
40 Coating device
50 Water supply device
60 Second cleaning device (film cleaning device, second heat-resistant polymer film cleaning device)
70 Laminating device (roll laminating device)
80 Appearance inspecting device
100 First sheet (inorganic substrate, metal foil, first heat-resistant polymer film)
102 Second sheet (heat-resistant polymer film, second heat-resistant polymer film)
104 Laminate
400 Laminate roll
1000, 2000 Apparatus for manufacturing laminate roll

**Claims**

1. An apparatus for manufacturing a laminate, the apparatus comprising:

    a first sheet transporting device for transporting a first sheet;
    a water supply device for supplying an aqueous medium to a surface of a first sheet coated with a silane coupling agent and/or a surface of a second sheet coated with a silane coupling agent; and
    a laminating device for bonding the first sheet and the second sheet, which have been supplied with the aqueous medium, to each other.

2. The apparatus for manufacturing a laminate according to claim 1, which comprises a coating device for coating a first sheet with a silane coupling agent.

3. The apparatus for manufacturing a laminate according to claim 1 or 2, which comprises a first cleaning device for cleaning a first sheet before being supplied with an aqueous medium.

4. The apparatus for manufacturing a laminate according to any one of claims 1 to 3, which comprises a second cleaning device for cleaning a second sheet before being supplied with an aqueous medium.

5. A method for manufacturing a laminate, which is a method for manufacturing a laminate including a first sheet and a second sheet, the method comprising:

    a step A of supplying an aqueous medium to a surface of a first sheet coated with a silane coupling agent and/or a surface of a second sheet coated with a silane coupling agent; and
    a step B of bonding the first sheet and the second sheet, which have been supplied with the aqueous medium, to each other.

6. The method for manufacturing a laminate according to claim 5, which comprises a step X-1 of coating a first sheet with a silane coupling agent before the step A.

7. The method for manufacturing a laminate according to claim 6, which comprises a step X-2 of cleaning a first sheet before the step A.

8. The method for manufacturing a laminate according to any one of claims 5 to 7, which comprises a step X-3 of cleaning a second sheet before the step A.

9. The method for manufacturing a laminate according to any one of claims 5 to 8, which comprises a step X-4 of inspecting appearance of a laminate of a first sheet and a second sheet, which have been bonded to each other, after the step B.

# Fig.1

# Fig.2

Fig.3

Fig.4

## INTERNATIONAL SEARCH REPORT

| International application No. |
| --- |
| PCT/JP2020/024005 |

**A. CLASSIFICATION OF SUBJECT MATTER**
Int.Cl. B29C63/02(2006.01)i, B32B27/06(2006.01)i, C08J5/12(2006.01)i,
C08J5/18(2006.01)i, B32B15/08(2006.01)i, B32B37/00(2006.01)i,
B32B37/16(2006.01)i, G09F9/00(2006.01)i, G09F9/30(2006.01)i,
H01L21/02(2006.01)i, H01L21/304(2006.01)i, B29C65/48(2006.01)i,
B32B7/12(2006.01)i, B32B38/18(2006.01)i, C08J7/043(2020.01)i,
C08J7/12(2006.01)i
FI: B32B37/16, B29C63/02, B32B37/00, B32B38/18E, B29C65/48, H01L21/02B,
H01L21/02C, B32B27/06, G09F9/30310, G09F9/00342, B32B15/08A, C08J5/12,
C08J7/12A, H01L21/304643B, C08J5/18CEZ, C08J7/043CFG, B32B7/12
According to International Patent Classification (IPC) or to both national classification and IPC

**B. FIELDS SEARCHED**

Minimum documentation searched (classification system followed by classification symbols)
Int.Cl. B29C63/02, B32B27/06, C08J5/12, C08J5/18, B32B15/08, B32B37/00,
B32B37/16, G09F9/00, G09F9/30, H01L21/02, H01L21/304, B29C65/48,
B32B7/12, B32B38/18, C08J7/043, C08J7/12

Documentation searched other than minimum documentation to the extent that such documents are included in the fields searched
Published examined utility model applications of Japan       1922–1996
Published unexamined utility model applications of Japan     1971–2020
Registered utility model specifications of Japan             1996–2020
Published registered utility model applications of Japan     1994–2020

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | JP 2018-202308 A (TOYOBO CO., LTD.) 27.12.2018 (2018-12-27), claims, examples, paragraphs [0013], [0018] | 1–9 |
| X | JP 2012-041418 A (SUMITOMO METAL MINING CO., LTD.) 01.03.2012 (2012-03-01), claims, examples | 1–9 |
| X | JP 2011-063760 A (SEIKO EPSON CORPORATION) 31.03.2011 (2011-03-31), claims, paragraphs [0046]–[0052], fig. 4 | 1, 2, 5, 6, 9 |

☒ Further documents are listed in the continuation of Box C.    ☒ See patent family annex.

| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 19.08.2020 | 01.09.2020 |

| Name and mailing address of the ISA/ | Authorized officer |
| --- | --- |
| Japan Patent Office 3-4-3, Kasumigaseki, Chiyoda-ku, Tokyo 100-8915, Japan | Telephone No. |

Form PCT/ISA/210 (second sheet) (January 2015)

**EP 4 039 447 A1**

C (Continuation).  DOCUMENTS CONSIDERED TO BE RELEVANT

| Category* | Citation of document, with indication, where appropriate, of the relevant passages | Relevant to claim No. |
|---|---|---|
| A | JP 2017-202570 A (TOYOBO CO., LTD.) 16.11.2017 (2017-11-16), abstract | 1-9 |
| A | JP 2010-168535 A (SUMITOMO METAL MINING CO., LTD.) 05.08.2010 (2010-08-05), abstract | 1-9 |
| A | JP 2015-178237 A (TOYOBO CO., LTD.) 08.10.2015 (2015-10-08), abstract | 1-9 |

Form PCT/ISA/210 (second sheet) (January 2015)

<table>
<tr><td colspan="2" align="center"><strong>INTERNATIONAL SEARCH REPORT</strong><br>Information on patent family members</td><td>International application No.<br><br>PCT/JP2020/024005</td></tr>
</table>

| | | |
|---|---|---|
| JP 2018-202308 A | 27.12.2018 | (Family: none) |
| JP 2012-041418 A | 01.03.2012 | (Family: none) |
| JP 2011-063760 A | 31.03.2011 | (Family: none) |
| JP 2017-202570 A | 16.11.2017 | (Family: none) |
| JP 2010-168535 A | 05.08.2010 | (Family: none) |
| JP 2015-178237 A | 08.10.2015 | (Family: none) |

Form PCT/ISA/210 (patent family annex) (January 2015)

**EP 4 039 447 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5152104 B
- JP 5304490 B
- JP 5531781 B
- JP 2015178237 A